# EUROPEAN PATENT APPLICATION

(11) **EP 4 575 529 A1**
(43) Date of publication of application: **25.06.2025**
(21) Application number: 23893604.1
(22) Date of filing: 01.11.2023
(51) Int. Cl.: G01R 31/12

(54) **INSULATION STATE DETECTION METHOD, SYSTEM AND DEVICE, STORAGE MEDIUM, AND PROGRAM PRODUCT**

(30) Priority: 23.11.2022 CN 202211474150
(71) Applicant: CONTEMPORARY AMPEREX TECHNOLOGY (HONG KONG) LIMITED, Central (HK)
(72) Inventor: LI, Xin, Ningde, Fujian 352100 (CN); LIU, Ping, Ningde, Fujian 352100 (CN); ZHANG, Miaomiao, Ningde, Fujian 352100 (CN); XU, Nan, Ningde, Fujian 352100 (CN)
(74) Representative: Ziebig Hengelhaupt Intellectual Property Attorneys Patentanwaltskanzlei PartGmbB
(86) International application number: PCT/CN2023/129114
(87) International publication number: WO 2024/109513

(57) **Abstract**

This application relates to an insulation state detection method, system, and apparatus as well as a storage medium and a program product. This method is applied to an energy management system. The energy management system is communicatively connected to a plurality of to-be-monitored components and one insulation monitoring module separately. All the to-be-monitored components and the insulation monitoring module are connected to a same direct-current bus in parallel. The method includes: detecting, by the insulation monitoring module in response to switching the insulation monitoring module to an on-state, an insulation state of each to-be-monitored component and an energy storage system sequentially based on a power-up and power-down sequence of the to-be-monitored components. This method simplifies a process of detecting the insulation fault of the energy storage system, thereby reducing complexity of the process of detecting the insulation fault of the energy storage system.

## Description

### CROSS-REFERENCE TO RELATED APPLICATIONS

This application claims priority to Chinese Patent Application No. 2022114741507, filed on November 23, 2022 and entitled "INSULATION STATE DETECTION METHOD, SYSTEM, AND APPARATUS, STORAGE MEDIUM, AND PROGRAM PRODUCT", which is incorporated herein by reference in its entirety.

### TECHNICAL FIELD

This application relates to the field of electric power technology, and in particular, to an insulation state detection method, system, and apparatus, a storage medium, and a program product.

### BACKGROUND

With the rapid development of energy storage technology, energy storage systems have been widely used in high-energy scenarios. Therefore, it is essential to ensure the safety of an energy storage system.

Generally, the safe and stable operation of the energy storage system can be ensured by troubleshooting various faults in the energy storage system. For example, the faults of an energy storage system may include an insulation fault, a leakage current fault, a temperature fault, and the like. Using an insulation fault as an example, in some scenarios, a process of detecting the insulation fault of the energy storage system is to inspect components on each branch of the energy storage system one by one, thereby resulting in a complicated process of detecting the insulation fault of the energy storage system.

### SUMMARY

In view of the above background and the technical problems, it is necessary to provide an insulation state detection method, system, and apparatus as well as a storage medium and a program product to simplify the process of detecting the insulation fault of an energy storage system, and in turn, reduce complexity of the process of detecting the insulation fault of the energy storage system.

According to a first aspect, this application provides an insulation state detection method, applied to an energy management system. The energy management system is communicatively connected to a plurality of to-be-monitored components and one insulation monitoring module separately. All the to-be-monitored components and the insulation monitoring module are connected to the same direct-current bus in parallel.

The method includes: detecting, by the insulation monitoring module in response to switching the insulation monitoring module to an on-state, an insulation state of each to-be-monitored component and an energy storage system sequentially based on a power-up and power-down sequence of the to-be-monitored components.

In the technical solution according to this embodiment of this application, the energy management system is communicatively connected to a plurality of to-be-monitored components and one insulation monitoring module. In addition, all the to-be-monitored components and the insulation monitoring module are connected to the same direct-current bus in parallel. Such an arrangement makes the line connection relationship simple. During the insulation state detection, the insulation states of a plurality of to-be-monitored components and the energy storage system can be detected by just one insulation monitoring module, thereby reducing the hardware cost in the process of detecting the insulation state. Moreover, the insulation states of the to-be-monitored components and the energy storage system are detected with reference to the power-up and power-down sequence of the to-be-monitored components. In this way, on the basis of simple line connection, the insulation states of the to-be-monitored components and the energy storage system can be detected in an orderly manner based on the preset the power-up and power-down sequence, thereby reducing the number of interactions in the detection process, simplifying the process of detecting the insulation fault of the to-be-monitored components and the energy storage system, and reducing the complexity of the process of detecting the insulation fault of the energy storage system.

In an embodiment, the power-up and power-down sequence includes a low-voltage power-up state and a high-voltage power-up sequence. The detecting, by the insulation monitoring module, an insulation state of each to-be-monitored component and an energy storage system sequentially based on a power-up and power-down sequence of the to-be-monitored components includes:
obtaining the low-voltage power-up state of each to-be-monitored component and the high-voltage power-up sequence of high-voltage components in all the to-be-monitored components; and
detecting, by the insulation monitoring module, the insulation state of each to-be-monitored component and the energy storage system sequentially based on the low-voltage power-up state of each to-be-monitored component and the high-voltage power-up sequence of the high-voltage components in all the to-be-monitored components.

In the technical solution according to this embodiment of this application, the power-up and power-down sequence of the to-be-monitored components is divided into a low-voltage power-up state and a high-voltage power-up sequence of the to-be-monitored components. In this way, when the insulation monitoring module detects the insulation state of each to-be-monitored component and the energy storage system, the detection logic can be as detailed as the low-voltage power-up state of each to-be-monitored component and the high-voltage power-up sequence of the high-voltage components in all the to-be-monitored components. The power-up sequence of the components in the energy storage system is to power up the low-voltage components first and then power up the high-voltage components. This power-up sequence is equivalent to a power-up and power-down sequence that is set with reference to the power-up requirements of the components in the energy storage system, thereby improving the reliability in detecting the insulation state of each to-be-monitored component and the energy storage system. In some exemplary embodiments, the high-voltage power-up sequence is a sequence for high-voltage components. Therefore, the high-voltage components are sequentially powered up with a high voltage in specified order, thereby enabling the insulation monitoring module to detect the insulation state of the high-voltage components in an orderly manner, and reducing the number of interactions in detecting the insulation state of the high-voltage components. This can not only reduce the complexity of detecting the insulation state of the high-voltage components, but also greatly shorten the detection time for the insulation state of the high-voltage components, and improve the detection efficiency of the insulation state.

In an embodiment, the detecting, by the insulation monitoring module, the insulation state of each to-be-monitored component and the energy storage system sequentially based on the low-voltage power-up state of each to-be-monitored component and the high-voltage power-up sequence of the high-voltage components in all the to-be-monitored components includes:
detecting, by the insulation monitoring module, the insulation state of a low-voltage component in all the to-be-monitored components after a low voltage is applied to all the to-be-monitored components; and
detecting, by the insulation monitoring module, the insulation state of each high-voltage component and the energy storage system based on the high-voltage power-up sequence of the high-voltage components in all the to-be-monitored components in a case that all low-voltage components have passed the insulation state detection.

In the technical solution according to this embodiment of this application, after a low voltage is applied to each to-be-monitored component, the insulation monitoring module detects the insulation states of the low-voltage components in the to-be-monitored components. If all the low-voltage components have passed the insulation state detection, the insulation monitoring module detects the insulation states of each high-voltage component and the energy storage system based on the high-voltage power-up sequence of the high-voltage components in all the to-be-monitored components. This application divides the power-up process into low-voltage power-up and high-voltage power-up. The to-be-monitored components are correspondingly divided into low-voltage components and high-voltage components. In a process of low-voltage power-up and high-voltage power-up, the insulation monitoring module detects the insulation state of the low-voltage components and the high-voltage components sequentially, thereby determining an overall detection result of the insulation states of the low-voltage components and an overall detection result of the insulation states of the high-voltage components in all the to-be-monitored components. Further, in some exemplary embodiments, based on the high-voltage power-up sequence of the high-voltage components, the insulation monitoring module detects the insulation states of a plurality of high-voltage components in the to-be-monitored components, thereby reducing the number of interactions of the to-be-monitored components during the insulation state detection in the low-voltage power-up process and the high-voltage power-up process, and further reducing the complexity of the detection process of each to-be-monitored component.

In an embodiment, the detecting, by the insulation monitoring module, the insulation state of a low-voltage component in all the to-be-monitored components includes:
obtaining an insulation resistance, detected by the insulation monitoring module, of the low-voltage component; and
determining a detection result of the insulation state of the low-voltage component based on the insulation resistance of the low-voltage component.

In the technical solution according to this embodiment of this application, when monitoring the low-voltage components, the insulation monitoring module does not need to distinguish a specific low-voltage component. The insulation monitoring module can quickly detect the insulation resistances of all the low-voltage components. After obtaining the insulation resistances of the low-voltage components in time, the insulation monitoring module can analyze the insulation resistances of the low-voltage components, thereby determining the detection result of the insulation state of the low-voltage components quickly, and improving the efficiency of the insulation detection of the low-voltage components.

In an embodiment, the determining a detection result of the insulation state of the low-voltage component based on the insulation resistance of the low-voltage component includes:
comparing the insulation resistance of the low-voltage component with a preset insulation fault resistance; and
determining, in a case that the insulation resistance of the low-voltage component is less than the insulation fault resistance, that the detection result of the insulation state of the low-voltage component is occurrence of an insulation fault; or, determining, in a case that the insulation resistance of the low-voltage component is greater than or equal to the insulation fault resistance, that the low-voltage component passes the insulation state detection.

In the technical solution according to this embodiment of this application, the insulation resistance of the low-voltage component is compared with the preset insulation fault resistance. In the case that the insulation resistance of the low-voltage component is less than the insulation fault resistance, it is determined that the detection result of the insulation state of the low-voltage component is occurrence of an insulation fault. In the case that the insulation resistance of the low-voltage component is greater than or equal to the insulation fault resistance, it is determined that the low-voltage component passes the insulation state detection. Based on the result of comparison between the insulation resistance of the low-voltage component and the preset insulation fault resistance, the detection result of the insulation state of the low-voltage component can be determined accurately, thereby accurately determining whether an insulation fault occurs in the low-voltage component.

In an embodiment, the detecting, by the insulation monitoring module, the insulation state of each high-voltage component and the energy storage system based on the high-voltage power-up sequence of the high-voltage components in all the to-be-monitored components includes:
performing, based on the high-voltage power-up sequence of the high-voltage components, an insulation detection operation on each high-voltage component powered up with the high voltage, so as to detect the insulation state of each high-voltage component; and
detecting the insulation state of the energy storage system in a case that a high voltage has been applied to all the high-voltage components and all the high-voltage components have passed the insulation state detection.

In the technical solution according to this embodiment of this application, in a process of powering up each high-voltage component with a high voltage based on the high-voltage power-up sequence of the high-voltage components, the high-voltage power-up time of each high-voltage component is relatively short. Therefore, in a process of powering up each high-voltage component with a high voltage for a number of times, the time taken for the insulation monitoring module to perform insulation detection on the high-voltage component is also relatively short. In addition, the insulation resistance corresponding to each high-voltage component can be obtained through one insulation monitoring module. If all the high-voltage components have been powered up with a high voltage and have passed the insulation state detection, the insulation monitoring module can accurately detect the insulation state of the energy storage system. In this process, the insulation resistance of each high-voltage component is detected in real time by one insulation monitoring module, thereby reducing the number of interactions in the detection process and reducing the complexity of the detection process of the high-voltage component.

In an embodiment, the performing an insulation detection operation on each high-voltage component powered up with the high voltage includes:
controlling, for any one high-voltage component, the high-voltage component to get powered up with a high voltage, and obtaining, by the insulation monitoring module, an insulation resistance of the high-voltage component powered up with the high voltage;
determining a detection result of the insulation state of the high-voltage component based on the insulation resistance of the high-voltage component powered up with the high voltage; and
controlling, based on the high-voltage power-up sequence after obtaining the detection result of the insulation state of the high-voltage component, a high-voltage component next to the high-voltage component to get powered up with a high voltage until detection results of insulation states of all high-voltage components are obtained.

In the technical solution according to this embodiment of this application, for any one high-voltage component, the high-voltage component is controlled to be powered up with a high voltage, and the insulation monitoring module accurately obtains the insulation resistance of the high-voltage component that has been powered up with a high voltage. The detection result of the insulation state of the high-voltage component can be accurately determined based on the insulation resistance of the high-voltage component that has been powered up with a high voltage. If the high-voltage component passes the insulation state detection, a high-voltage component next to the high-voltage component is controlled to be powered up with a high voltage based on the high-voltage power-up sequence until the detection results of insulation states of all the high-voltage components are obtained. The insulation states of the high-voltage components are detected in an iterative manner, so that the detection process for the high-voltage components is more standardized, thereby achieving a more accurate detection result of the insulation state of the high-voltage component. In addition, all the high-voltage components are monitored in real time by one insulation monitoring module, thereby reducing the detection cost, reducing the number of interactions in the detection process, and reducing the interaction complexity.

In an embodiment, the controlling a high-voltage component to get powered up with a high voltage includes:
sending a high-voltage power-up instruction to the high-voltage component, so as to instruct the high-voltage component to turn off an internal relay and get powered up with a high voltage based on the high-voltage power-up instruction; and
receiving a high-voltage power-up completion instruction returned by the high-voltage component, and determining that the high-voltage component has been powered up with the high voltage.

In the technical solution according to this embodiment of this application, a high-voltage power-up instruction is sent to the high-voltage component to instruct the high-voltage component to turn off the internal relay and complete the high-voltage power-up based on the high-voltage power-up instruction. After the high-voltage component is powered up with a high voltage, a high-voltage power-up completion instruction returned by the high-voltage component is received. For each high-voltage component, by sending the high-voltage power-up instruction and receiving the high-voltage power-up completion instruction, this application can apply a high voltage to each high-voltage component more accurately based on the high-voltage power-up sequence of the high-voltage components, thereby avoiding disorder of the high-voltage power-up process of the high-voltage components. In a process of monitoring the high-voltage components, the insulation monitoring module does not need to be frequently turned on or off, thereby reducing the number of interactions in the detection process, and reducing the complexity of the detection process for the high-voltage components.

In an embodiment, the determining a detection result of the insulation state of the high-voltage component based on the insulation resistance of the high-voltage component powered up with the high voltage includes:
comparing the insulation resistance of the high-voltage component with a preset insulation fault resistance; and
determining, in a case that the insulation resistance of the high-voltage component is less than the insulation fault resistance, that the detection result of the insulation state of the high-voltage component is occurrence of an insulation fault; or, determining, in a case that the insulation resistance of the high-voltage component is greater than or equal to the insulation fault resistance, that the high-voltage component passes the insulation state detection.

In the technical solution according to this embodiment of this application, the insulation resistance of the high-voltage component is compared with the preset insulation fault resistance. In the case that the insulation resistance of the high-voltage component is less than the insulation fault resistance, it is determined that the detection result of the insulation state of the high-voltage component is occurrence of an insulation fault. In the case that the insulation resistance of the high-voltage component is greater than or equal to the insulation fault resistance, it is determined that the high-voltage component passes the insulation state detection. Based on the result of comparison between the insulation resistance of the high-voltage component and the preset insulation fault resistance, the detection result of the insulation state of the high-voltage component can be determined accurately, thereby accurately determining whether an insulation fault occurs in the high-voltage component.

In an embodiment, the detecting the insulation state of the energy storage system includes:
detecting, by the insulation monitoring module, an insulation resistance of the energy storage system; and
determining a detection result of the insulation state of the energy storage system based on the insulation resistance of the energy storage system.

In the technical solution according to this embodiment of this application, when the insulation monitoring module monitors the energy storage system, it is necessary to specifically distinguish the energy storage system. The insulation resistance of the entire energy storage system can be detected by the insulation monitoring module, thereby quickly determining whether an insulation fault occurs in the energy storage system in normal operation. In addition, one insulation monitoring module can not only monitor all the to-be-monitored components, but also monitor the entire energy storage system, thereby reducing the hardware cost in the insulation detection for the energy storage system.

In an embodiment, the determining a detection result of the insulation state of the energy storage system based on the insulation resistance of the energy storage system includes:
comparing the insulation resistance of the energy storage system with a preset insulation fault resistance; and
determining, in a case that the insulation resistance of the energy storage system is less than the insulation fault resistance, that the detection result of the insulation state of the energy storage system is occurrence of an insulation fault; or, determining, in a case that the insulation resistance of the energy storage system is greater than or equal to the insulation fault resistance, that the energy storage system passes the insulation state detection.

In the technical solution according to this embodiment of this application, the insulation resistance of the energy storage system is compared with the preset insulation fault resistance. In the case that the insulation resistance of the energy storage system is less than the insulation fault resistance, it is determined that the detection result of the insulation state of the energy storage system is occurrence of an insulation fault. In the case that the insulation resistance of the energy storage system is greater than or equal to the insulation fault resistance, it is determined that the energy storage system passes the insulation state detection. Based on the result of comparison between the insulation resistance of the energy storage system and the preset insulation fault resistance, the detection result of the insulation state of the energy storage system can be determined accurately, thereby accurately determining whether an insulation fault occurs in the energy storage system.

In an embodiment, the method further includes:
issuing a high-voltage power-down instruction to each high-voltage component in a case that the detection result of the insulation state of the energy storage system is occurrence of an insulation fault, so as to instruct each high-voltage component to get disconnected from the high voltage;
performing an insulation detection operation on each high-voltage component after the high-voltage component is disconnected from the high voltage, so as to determine a detection result of the insulation state of each high-voltage component; and
determining, based on the detection result of the insulation state of each high-voltage component, a high-voltage component that causes the insulation fault of the energy storage system.

In the technical solution according to this embodiment of this application, if the detection result of the insulation state of the energy storage system is occurrence of an insulation fault, it means that an insulation fault occurs during normal operation of the energy storage system, but without determining the to-be-monitored component on which the insulation fault occurs in the energy storage system. A high-voltage power-down instruction is issued to all the high-voltage components to instruct all the high-voltage components to be disconnected from the high voltage. After all the high-voltage components are disconnected from the high voltage, it is ensured that all the to-be-monitored components are in a low-voltage state, so as to determine whether an insulation fault occurs in the low-voltage components. If no insulation fault occurs in any low-voltage component, an insulation detection operation is performed on each high-voltage component powered up with the high voltage, so as to obtain an insulation resistance corresponding to each high-voltage component. In this way, all the high-voltage components are accurately troubleshot based on the insulation resistance, so as to determine a detection result of the insulation state of each high-voltage component. Based on the detection result of the insulation state of each high-voltage component, the high-voltage component that causes the insulation fault of the energy storage system can be accurately determined, thereby improving the accuracy of insulation state detection.

In an embodiment, before the response to switching the insulation monitoring module to the on-state, the method further includes: sending an insulation detection start instruction to the insulation monitoring module in a case that each to-be-monitored component is powered up with a low voltage, where the insulation detection start instruction is used for switching the insulation monitoring module to the on-state.

In the technical solution according to this embodiment of this application, upon detecting that a to-be-monitored component is powered up with a low voltage, an insulation detection start instruction is promptly sent to the insulation monitoring module, so that the insulation monitoring module is switched to the on-state. The insulation monitoring module stays in the on-state without being automatically turned off. In the entire process, the insulation monitoring module can detect the insulation resistance of each to-be-monitored component in real time, thereby preventing the insulation monitoring module from being turned on or off repeatedly, reducing the number of interactions in the detection process, and reducing the complexity of interactions in the detection process.

In an embodiment, the method further includes: outputting a prompt message for any one to-be-monitored component in a case that the detection result of the insulation state of the to-be-monitored component is occurrence of an insulation fault, where the prompt message is used for instructing the to-be-monitored component to get troubleshot and repaired to remove the insulation fault.

In the technical solution according to this embodiment of this application, for any one to-be-monitored component, if the detection result of the insulation state of the to-be-monitored component is occurrence of an insulation fault, a prompt message can be output to a technician in time. The technician can troubleshoot and repair the to-be-monitored component with respect to the insulation fault in time to ensure the safe operation of the energy storage system.

According to a second aspect, this application further provides an insulation state detection system. The insulation state detection system includes a plurality of to-be-monitored components and one insulation monitoring module. The plurality of to-be-monitored components and the insulation monitoring module are all communicatively connected to an energy management system. All the to-be-monitored components and the insulation monitoring module are connected to the same direct-current bus in an energy storage system in parallel.

The energy management system is configured to detect, by the insulation monitoring module in response to switching the insulation monitoring module to an on-state, an insulation state of each to-be-monitored component and the energy storage system sequentially based on a power-up and power-down sequence of the to-be-monitored components.

In the technical solution according to this embodiment of this application, the energy management system is communicatively connected to a plurality of to-be-monitored components and one insulation monitoring module. In addition, all the to-be-monitored components and the insulation monitoring module are connected to the same direct-current bus in parallel. Such an arrangement makes the line connection relationship simple. During the insulation state detection, the insulation states of a plurality of to-be-monitored components and the energy storage system can be detected by just one insulation monitoring module, thereby reducing the hardware cost in the process of detecting the insulation state. Moreover, the insulation states of the to-be-monitored components and the energy storage system are detected with reference to the power-up and power-down sequence of the to-be-monitored components. In this way, on the basis of simple line connection, the insulation states of the to-be-monitored components and the energy storage system can be detected in an orderly manner based on the preset the power-up and power-down sequence, thereby reducing the number of interactions in the detection process, simplifying the process of detecting the insulation fault of the to-be-monitored components and the energy storage system, and reducing the complexity of the process of detecting the insulation fault of the energy storage system.

According to a third aspect, this application further provides an energy storage system. The energy storage system includes the insulation state detection system disclosed in the second aspect.

In the technical solution according to this embodiment of this application, the energy management system is communicatively connected to a plurality of to-be-monitored components and one insulation monitoring module. In addition, all the to-be-monitored components and the insulation monitoring module are connected to the same direct-current bus in parallel. Such an arrangement makes the line connection relationship simple. During the insulation state detection, the insulation states of a plurality of to-be-monitored components and the energy storage system can be detected by just one insulation monitoring module, thereby reducing the hardware cost in the process of detecting the insulation state. Moreover, the insulation states of the to-be-monitored components and the energy storage system are detected with reference to the power-up and power-down sequence of the to-be-monitored components. In this way, on the basis of simple line connection, the insulation states of the to-be-monitored components and the energy storage system can be detected in an orderly manner based on the preset the power-up and power-down sequence, thereby reducing the number of interactions in the detection process, simplifying the process of detecting the insulation fault of the to-be-monitored components and the energy storage system, and reducing the complexity of the process of detecting the insulation fault of the energy storage system.

According to a fourth aspect, this application further provides an insulation state detection apparatus.

The apparatus includes: a detection module, configured to: detect, by an insulation monitoring module in response to switching the insulation monitoring module to an on-state, an insulation state of each to-be-monitored component and an energy storage system sequentially based on a power-up and power-down sequence of the to-be-monitored components.

According to a fifth aspect, this application further provides a computer-readable storage medium. The computer-readable storage medium stores a computer program. When executed by a processor, the computer program performs the insulation state detection method disclosed in any one of the embodiments in the first aspect.

According to a sixth aspect, this application further provides a computer program product. The computer program product includes a computer program. When executed by a processor, the computer program implements the insulation state detection method disclosed in any one of the embodiments in the first aspect.

The foregoing description is merely an overview of the technical solutions of this application. Some specific embodiments of this application are described below illustratively to enable a clearer understanding of the technical solutions of this application, enable implementation of the technical solutions based on the subject-matter hereof, and make the foregoing and other objectives, features, and advantages of this application more evident and comprehensible.

### BRIEF DESCRIPTION OF DRAWINGS

To describe the technical solutions of some embodiments of this application more clearly, the following outlines the drawings used in the embodiments of this application. Evidently, the drawings outlined below are merely a part of embodiments of this application. A person of ordinary skill in the art may derive other drawings from the outlined drawings without making any creative efforts. In the drawings:
FIG. 1 is a schematic structural diagram of an energy storage system according to the prior art;
FIG. 2 is a schematic structural diagram of an energy storage system according to an embodiment of this application;
FIG. 3 is a schematic flowchart of an insulation state detection method according to an embodiment;
FIG. 4 is a schematic flowchart of an insulation state detection method according to an embodiment;
FIG. 5 is a schematic flowchart of an insulation state detection method according to an embodiment;
FIG. 6 is a schematic flowchart of an insulation state detection method according to an embodiment;
FIG. 7 is a schematic flowchart of an insulation state detection method according to an embodiment;
FIG. 8 is a schematic flowchart of an insulation state detection method according to an embodiment;
FIG. 9 is a schematic flowchart of an insulation state detection method according to an embodiment;
FIG. 10 is a schematic flowchart of an insulation state detection method according to an embodiment;
FIG. 11 is a schematic flowchart of an insulation state detection method according to an embodiment;
FIG. 12 is a schematic flowchart of an insulation state detection method according to an embodiment;
FIG. 13 is a schematic flowchart of an insulation state detection method according to an embodiment;
FIG. 14 is a schematic flowchart of an insulation state detection method according to an embodiment;
FIG. 15 is a schematic flowchart of an insulation state detection method according to an embodiment;
FIG. 16 is a schematic structural diagram of an energy storage system according to an embodiment; and
FIG. 17 is an internal structure diagram of a computer device according to an embodiment.

List of reference numerals:
11: energy storage system; 111: power conversion system; 112: battery management system; 12: power grid; 13: energy management system; 14: insulation monitoring module; 21: energy storage system; 211: electric cabinet; 2111: battery management system; 2112: direct-current chopper; 212: photovoltaic panel controller; 213: power conversion system; 2131: inverter; 2132: control unit; 22: insulation monitoring module.

### DETAILED DESCRIPTION OF EMBODIMENTS

Some embodiments of the technical solutions of this application are described in detail below with reference to the drawings. The following embodiments are merely intended as examples to describe the technical solutions of this application more clearly, but not intended to limit the protection scope of this application.

Unless otherwise defined, all technical and scientific terms used herein bear the same meanings as what is normally understood by a person skilled in the technical field of this application. The terms used herein are merely intended to describe specific embodiments but not to limit this application. The term "include" and any variations thereof used in the specification, claims, and brief description of drawings of this application are intended as non-exclusive inclusion.

Reference to an "embodiment" herein means that a specific feature, structure or characteristic described with reference to this embodiment may be included in at least one embodiment of this application. Reference to this term in different places in the specification does not necessarily represent the same embodiment, nor does it represent an independent or alternative embodiment in a mutually exclusive relationship with other embodiments. A person skilled in the art explicitly and implicitly understands that the embodiments described herein may be combined with other embodiments.

With the continuous development of new energy technology, a variety of energy storage systems are increasingly used in various fields. An energy storage system can provide electricity to users during peak hours or power outages. For example, energy storage systems are categorized into photovoltaic energy storage systems, wind energy storage systems, hydraulic energy storage systems, battery energy storage systems, and so on.

However, a variety of faults may occur in the energy storage system during use. For example, the fault types may include a thermal fault, an electrical fault, and a mechanical fault. Among such faults, an insulation fault among the electrical faults may cause safety accidents such as fires and explosions. To ensure the safe operation of the energy storage system, insulation detection needs to be performed on the devices inside the energy storage system to determine whether an insulation fault occurs in a device inside the energy storage system, so as to prevent safety accidents and ensure the safe operation of the energy storage system.

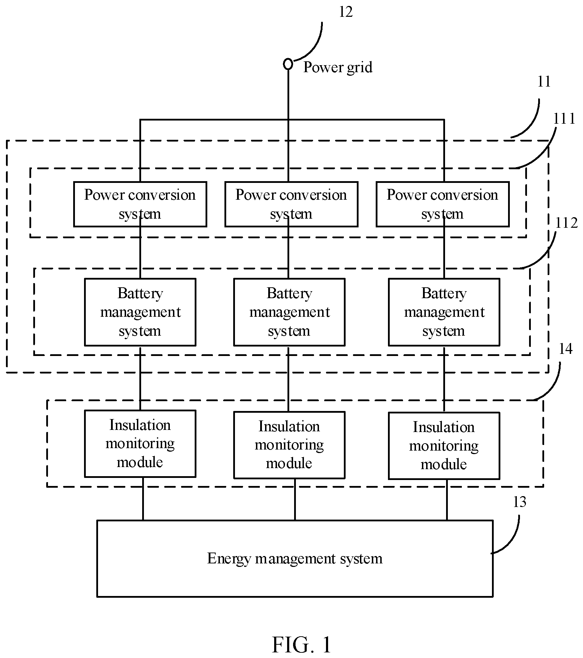

FIG. 1 is a schematic structural diagram of an energy storage system in the prior art. In FIG. 1, the energy storage system 11 includes a plurality of branches. Each of the branches includes power conversion system (PCS) 111 and a battery management system (BMS) 112. The power conversion system 111 is connected to the battery management system 112. The PCSs on the plurality of branches are all connected to a power grid 12, and the BMSs on the branches are all connected to an energy management system (EMS) 13. In order to perform insulation detection on the BMS on each branch inside the energy storage system 11, a plurality of insulation monitoring modules 14 are connected to the branches respectively. In this way, each insulation monitoring module 14 can perform insulation detection on this branch to determine whether the branch suffers an insulation fault.

The applicant hereof finds that in the related art, simultaneous detection by a plurality of insulation monitoring modules 14 induces mutual interference. The plurality of insulation monitoring modules 14 need to be turned on and off in circular order. In other words, during each detection process, the insulation monitoring module 14 on one branch is turned on, and the insulation monitoring modules 14 on other branches are turned off. In this case, the insulation monitoring module 14 on each branch is turned on during detection and turned off upon completion of the detection. The EMS needs to control the on-state and off-state of a plurality of insulation monitoring modules 14 simultaneously. The complexity interactions between each of the insulation monitoring modules 14 and the EMS during the detection is relatively high.

In view of this, as found by the applicant hereof through research, in the insulation detection method according to an embodiment of this application, one insulation monitoring module is disposed in the energy storage system, and the EMS just needs to control this insulation monitoring module to be on throughout the detection, and control this insulation monitoring module to be turned off upon completion of the detection, thereby greatly reducing the complexity of the interactions between each of the plurality of insulation monitoring modules and the EMS. In order to monitor the components such as PCS and BMS in the energy storage system through just one insulation monitoring module, the applicant hereof connects the insulation monitoring module and the components such as PCS and BMS in the energy storage system to the same direct-current bus, and arranges the time sequence of the detection for the components. In this way, the components such as PCS and BMS in the energy storage system work in different time periods separately, so that one insulation monitoring module detects different components. This process can reduce the number of interactions in the detection process, simplify the process of detecting the insulation fault, and reduce the complexity of the process of detecting the insulation fault of the energy storage system.

In some exemplary embodiments, the applicant hereof has also found through research that, in the prior art, each branch in the energy storage system 11 corresponds to one insulation monitoring module 14. For an energy storage system 11 with few branches, the number of insulation monitoring modules 14 is small, and the cost is not very high. However, if there are many branches in the energy storage system 11, the number of corresponding insulation monitoring modules 14 is large, thereby resulting in a relatively high hardware cost in the insulation detection of the energy storage system 11.

In view of this, as found by the applicant hereof through research, in the insulation detection method according to an embodiment of this application, by connecting one insulation monitoring module to the direct-current bus in parallel, this application can reduce the number of insulation monitoring modules. All the components connected to the same direct-current bus in parallel can be detected by just one insulation monitoring module, thereby greatly reducing the number of insulation monitoring modules in use and reducing the hardware cost in the insulation state detection.

The technical effects that can be achieved by the insulation state detection method and the energy storage system according to an embodiment of this application are not limited to those described above, and other technical effects may also be achieved. For example, because the insulation monitoring module and the components such as PCS and BMS in the energy storage system are all connected to the same direct-current bus in parallel, the line connection relationship within the energy storage system is simpler. For an energy storage system with a complex internal connection relationship, the technical solutions hereof can more effectively meet the insulation detection requirements of the energy storage system.

The insulation state detection method according to an embodiment of this application is applied to the energy storage system 11. In view of this, before description of the insulation state detection method according to an embodiment of this application, the energy storage system architecture used herein is described first.

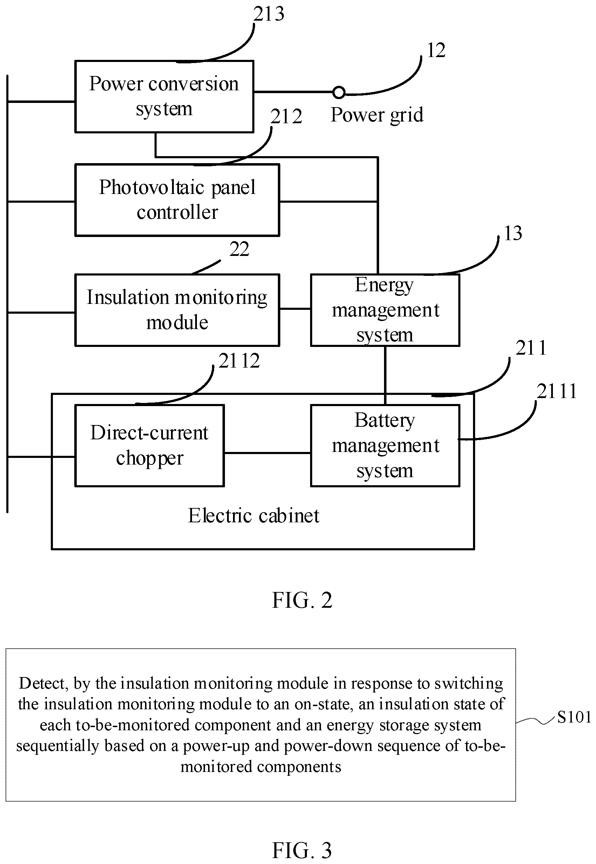

As shown in FIG. 2, FIG. 2 is a schematic structural diagram of an energy storage system according to an embodiment of this application. A plurality of to-be-monitored components in the energy storage system 21 may include an electric cabinet 211, a photovoltaic panel controller (Maximum Power Point Tracking, MPPT controller) 212, a power conversion system 213, and the like. The electric cabinet 211 may contain a battery management system 2111 and a direct-current chopper (Direct Current/Direct Current, DC/DC) 2112. The battery management system 2111 is connected to the direct-current chopper 2112. The insulation monitoring module 22, the direct-current chopper 2112, the photovoltaic panel controller 212, and the power conversion system 213 are connected to the same direct-current bus in parallel. The power conversion system 213 is connected to the power grid 12 and the direct-current bus separately, and is configured to convert the alternating current provided by the power grid 12 into a direct current, and provide electrical energy to the electric cabinet 211 and the photovoltaic panel controller 212.

The energy management system 13 communicates with the insulation monitoring module 22 and the plurality of to-be-monitored components in a communication mode that may be any one of CAN bus, Canbus communication, Modbus communication, RS485 communication, RS232 communication, or RS422 communication. The energy management system may be a computer-based insulation detection management module, and is capable of collecting insulation data of each component in the energy storage system and performing analysis, response, and control based on the insulation data.

In addition, the insulation monitoring module 22 and each to-be-monitored component are connected to the same direct-current bus in parallel. The positions at which the plurality of to-be-monitored components and the insulation monitoring module 22 are connected to the direct-current bus in parallel are not particularly limited herein. For example, the insulation monitoring module 22 may be disposed at two ends of the direct-current bus, and the plurality of to-be-monitored components may be disposed in the middle. Alternatively, the insulation monitoring module 22 may be disposed in the middle, and the plurality of to-be-monitored components may be disposed at both ends.

The insulation monitoring module 22 is configured to obtain an insulation parameter value of each to-be-monitored component. The insulation parameter value is used for characterizing the insulation state of each to-be-monitored component. For example, the insulation parameter may include a leakage current value, an insulation resistance, and the like of each to-be-monitored component. The energy management system may send an insulation detection start instruction to the insulation monitoring module, so as to control the insulation monitoring module to start detection. After the insulation monitoring module is turned on, the insulation monitoring module remains in the on-state. During the detection, without a need to switch frequently, the insulation monitoring module can detect the insulation parameter values of the energy storage system and each to-be-monitored component in real time, and transmit the obtained insulation parameter value of each to-be-monitored component to the energy management system 13. After receiving the insulation parameter of each to-be-monitored component, the energy management system 13 may detect the insulation state of each to-be-monitored component based on the insulation parameter of each to-be-monitored component. After the energy management system completes detecting the insulation state of the energy storage system and each to-be-monitored component, the energy management system sends an insulation detection halt instruction to the insulation monitoring module. Upon receiving the insulation detection halt instruction, the insulation monitoring module halts the detection of the insulation parameter values of the energy storage system and each to-be-monitored component. The insulation monitoring module 22 may be a pointer-type insulation resistance tester or a digital insulation resistance tester.

The power conversion system 213 is configured to obtain electrical energy from the power grid, or release electrical energy to the power grid. The power conversion system 213 includes an inverter 2131 (Direct Current/Alternating Current, DC/AC) and a control unit 2132. The inverter 2131 is configured to convert the direct current provided by the power grid into alternating current. The control unit 2132 is configured to receive a control instruction sent by the energy management system 13. Based on the control instruction, the photovoltaic panel controller 212 or the battery management unit 2111 inside the energy storage system 21 are charged or discharged, so as to regulate the active power and reactive power of the power grid.

In some exemplary embodiments, the connection relationship between the components inside the energy storage system is changed in the above manner, and all the components can be monitored by one insulation monitoring module. The energy management system 13 interacts with this insulation monitoring module, thereby avoiding the interactions between the energy management system 13 and a plurality of insulation monitoring modules, and reducing the complexity of the interaction process. In addition, the use of just one insulation monitoring module can greatly reduce the hardware cost of insulation detection.

Understandably, the design of each structure in the energy storage system in the above embodiment is merely one example of achieving the technical effects of this application. In practical applications, the design may be adapted to achieve easily conceivable technical effects. The structure is not particularly herein.

Next, the insulation state detection method according to an embodiment of this application is described. The insulation state detection method in an embodiment of this application described by using an example in which the method is applied to the energy storage system in FIG. 2 and performed by the energy management system 13.

In an embodiment, as shown in FIG. 3, the method includes the following steps:
S101: Detecting, by the insulation monitoring module in response to switching the insulation monitoring module to an on-state, an insulation state of each to-be-monitored component and an energy storage system sequentially based on a power-up and power-down sequence of the to-be-monitored components.

During operation of the energy storage system, fault detection needs to be performed on the energy storage system at preset intervals to ensure that the energy storage system can operate safely and stably. Before detecting the insulation state of the energy storage system and each to-be-monitored component in the energy storage system, the insulation monitoring module is in the off-state. The energy management system needs to send an insulation detection start instruction to the insulation monitoring module. Upon receiving the insulation detection start instruction, the insulation monitoring module starts detecting the insulation parameter values of the energy storage system and each to-be-monitored component.

When the insulation monitoring module is in the on-state, the energy management system controls each to-be-monitored component to get powered up or down. During the power-up and power-down, the insulation monitoring module detects the insulation parameter value of each to-be-monitored component and sends, to the energy management system, the applied or removed voltage and the insulation parameter value of each to-be-monitored component corresponding to the applied or removed voltage. The energy management system determines the insulation state of each to-be-monitored component and the energy storage system based on the applied or removed voltage and the insulation parameter value of each to-be-monitored component powered up with or disconnected from the voltage. The insulation state includes insulation failure and normal insulation. Using the to-be-monitored component A as an example, when the to-be-monitored component A passes the insulation state detection, no insulation failure occurs in the to-be-monitored component A, and the insulation parameter value of the to-be-monitored component is greater than the preset resistance value, or, the insulation parameter value of the to-be-monitored component is the same as the rated resistance value. The to-be-monitored component is protected properly to ensure the safety of the energy storage system. When the to-be-monitored component A fails the insulation state detection, an insulation failure occurs in the to-be-monitored component A, and the insulation parameter value of the to-be-monitored component is less than the preset resistance value. The to-be-monitored component is not protected properly and is prone to cause fire, explosion, or other safety accidents to the energy storage system due to the insulation failure.

The power-up and power-down sequence means a sequence in which the to-be-monitored components in the energy storage system are powered up or down. Without considering whether a high voltage or low voltage is applied during the power-up or power-down, the energy management system generally controls the to-be-monitored components in the energy storage system to get powered up in preset power-up order, or controls the to-be-monitored components to get powered up simultaneously. After all the to-be-monitored components are powered up with a high voltage, the energy management system controls the to-be-monitored components to get powered down in preset power-down order, or controls the to-be-monitored components to get powered down simultaneously.

Considering the high voltage or low voltage applied during the power-up or power-down, the to-be-monitored components may be divided into low-voltage components and high-voltage components. The energy management system may control the low-voltage components to get powered up with a low voltage first. When it is determined that no insulation fault exists in the low-voltage components, the energy management system controls the high-voltage components to get powered up with a high voltage in the preset high-voltage power-up order, or controls all the high-voltage components to get powered up with a high voltage simultaneously. When it is determined that no insulation fault exists in the high-voltage components, the insulation monitoring module determines whether an insulation fault occurs in the energy storage system in normal operation. If no insulation fault occurs in the energy storage system, no high-voltage power-down needs to be performed. If an insulation fault occurs in the energy storage system, the energy management system controls the high-voltage components to disconnect from the high voltage in the high-voltage power-down order, or, controls all the high-voltage components to disconnect from the high voltage simultaneously, and then identifies the specific to-be-monitored component with the insulation fault among all the to-be-monitored components in the power-on order in a case that the energy storage system is operating normally. For example, the low-voltage components may include a photovoltaic panel controller, a direct-current side device of the PCS, and the like; and the high-voltage components may include a BMS in the electric cabinet, a direct-current chopper in the electric cabinet, an alternating-current side device of the PCS, and the like.

Understandably, when the insulation monitoring module monitors the to-be-monitored components based on the power-up and power-down sequence, each insulation parameter value detected may represent the insulation parameter value of a specific to-be-monitored component, or represent the insulation parameter value of several to-be-monitored components, or represent the insulation parameter value of the entire energy storage system. For example, in a process of powering up the to-be-monitored components by using a low voltage, the insulation parameter values detected by the insulation monitoring module include the insulation parameter value common to the photovoltaic panel controller and the direct-current side device of the PCS; in a process of powering up the PCS by using a high voltage, the insulation parameter value detected by the insulation monitoring module is the insulation parameter value of the alternating-current side device of the PCS.

In the above insulation state detection method, the energy management system is communicatively connected to a plurality of to-be-monitored components and one insulation monitoring module. In addition, all the to-be-monitored components and the insulation monitoring module are connected to the same direct-current bus in parallel. Such an arrangement makes the line connection relationship simple. During the insulation state detection, the insulation states of a plurality of to-be-monitored components and the energy storage system can be detected by just one insulation monitoring module, thereby reducing the hardware cost in the process of detecting the insulation state. Moreover, the insulation state of each to-be-monitored component and the energy storage system is detected with reference to the power-up and power-down sequence of the to-be-monitored components. In this way, on the basis of a simple line connection manner, the insulation state of each to-be-monitored component and the energy storage system can be detected in an orderly manner based on the preset the power-up and power-down sequence, thereby reducing the number of interactions in the detection process, simplifying the process of detecting the insulation fault of each to-be-monitored component and the energy storage system, and reducing the complexity of the process of detecting the insulation fault of the energy storage system.

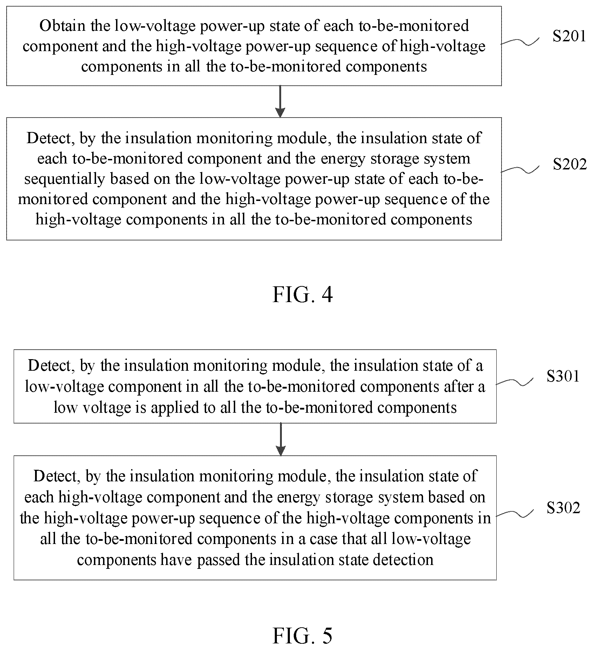

On the basis of the above embodiment, the following embodiment describes the details of "detecting, by the insulation monitoring module, an insulation state of each to-be-monitored component and an energy storage system sequentially based on a power-up and power-down sequence of the to-be-monitored components" in step S101 in the embodiment shown in FIG. 3. As shown in FIG. 4, the process of the insulation state detection may include the following steps:
S201: Obtaining the low-voltage power-up state of each to-be-monitored component and the high-voltage power-up sequence of high-voltage components in all the to-be-monitored components.

High voltage and low voltage are based on the voltage value with respect to the ground. The boundary between high voltage and low voltage is AC 1000 volts (V) or DC 1500 V. A component working at a voltage lower than AC 1000 V or lower than DC 1500 V is a low-voltage component, and a component working at AC 1000 V or above or DC 1500 V or above is a high-voltage component. For example, the low-voltage components in the to-be-monitored components in the energy storage system may be a photovoltaic panel controller, a direct-current side device of the PCS; and the high-voltage components in the to-be-monitored components may be an electric cabinet, a BMS in the electric cabinet, a direct-current chopper in the electric cabinet, an alternating-current side device of the PCS.

The low-voltage power-up state means a state of a to-be-monitored component powered up with a low voltage. When a to-be-monitored component is in the low-voltage power-up state, the insulation monitoring module can detect the insulation parameter value of the low-voltage component in the to-be-monitored components. The high-voltage power-up sequence means the order in which the high-voltage components are powered up with a high voltage. For example, the high-voltage power-up sequence may be from the BMS to the direct-current chopper and then to the inverter. To be specific, under the control of the energy management system, the BMS is powered up first with a high voltage; after completion of powering up the BMS with a high voltage, the direct-current chopper is powered up with a high voltage; after completion of powering up the direct-current chopper with a high voltage, the entire electric cabinet completes the high-voltage power-up operation; and finally, the inverter is powered up with a high voltage. After completion of powering up the inverter with a high voltage, the entire energy storage system completes the high-voltage power-up.

During a low-voltage power-up operation for each to-be-monitored component, in some exemplary embodiments, a direct-current bus may be charged through a discharge operation of the MPPT controller, thereby providing a low voltage to each to-be-monitored component. In some exemplary embodiments, when no voltage is stored in the MPPT controller, the voltage may be obtained from the power grid through the inverter, so as to charge the direct-current bus, and in turn, provide a low voltage to each to-be-monitored component. The process of low voltage operations of each to-be-monitored component occurs spontaneously but is not triggered by low-voltage power-up under the control of the energy management system.

In these embodiments, in a process of powering up the to-be-monitored components by using a low voltage, the insulation monitoring module may detect the insulation parameter value of a low-voltage component in the to-be-monitored components, and send the insulation parameter value to the energy management system. Upon receiving the insulation parameter value, the energy management system determines whether each to-be-monitored component is in a low-voltage power-up state.

In some exemplary embodiments, the energy management system may determine that a historical high-voltage sequence of the high-voltage components is the high-voltage power-up sequence of the high-voltage components. In some exemplary embodiments, the energy management system may sort the high-voltage components based on the number of historical insulation faults of each high-voltage component, so as to obtain a resulting sequence of the high-voltage components; and then determine that the resulting sequence is the power-up sequence of the high-voltage components. The method for obtaining the high-voltage power-up sequence of the high-voltage components is not particularly limited herein.

S202: Detecting, by the insulation monitoring module, the insulation state of each to-be-monitored component and the energy storage system sequentially based on the low-voltage power-up state of each to-be-monitored component and the high-voltage power-up sequence of the high-voltage components in all the to-be-monitored components.

In a process of powering up each to-be-monitored component by using a low voltage, the insulation monitoring module may obtain the insulation parameter value of each to-be-monitored component in real time. At this time, the value detected by the insulation monitoring module is an insulation parameter value common to the low-voltage component in the to-be-monitored components and the direct-current bus. Based on this insulation parameter value, the insulation monitoring module determines the insulation state of the low-voltage component and the direct-current bus, that is, determines whether the low-voltage component or the direct-current bus is faulty. If a fault occurs, it is determined that the low-voltage component or the direct-current bus is faulty, but it is not determined whether a low-voltage component or the direct-current bus is faulty, and it is even more uncertain which specific low-voltage component is faulty. Next, the technician needs to troubleshoot the low-voltage components and the direct-current bus separately to determine the specific faulty component. In some exemplary embodiments, due to a small resistance of the direct-current bus, it is just necessary to determine whether a low-voltage component is faulty, without considering the direct-current bus.

In this embodiment, the energy management system may determine, based on the insulation parameter value of each to-be-monitored component collected by the insulation monitoring module, whether each to-be-monitored component is in a low-voltage power-up state or not. If it is determined that a to-be-monitored component has been powered up with a low voltage, the energy management system determines whether the low-voltage component has passed the insulation state detection. If the low-voltage component has passed the insulation state detection, then no insulation fault occurs in the low-voltage component, and the energy management system controls the high-voltage components to get powered up with a high voltage. If the low-voltage component fails the insulation state detection, an insulation fault occurs in the low-voltage component. The energy management system feeds back the insulation fault information to the technician so that the technician can troubleshoot the low-voltage component based on the insulation fault information.

After the low voltage is applied to all the to-be-monitored components and after it is determined that no fault occurs in the low-voltage components or the direct-current bus, the high-voltage components are powered up with a high voltage sequentially based on the high-voltage power-up sequence of the high-voltage components. The energy management system may power up the high-voltage components in the to-be-monitored components sequentially by use of a high voltage based on the high-voltage power-up sequence of the high-voltage components, and determine whether all the high-voltage components have passed the insulation state detection, that is, determine whether any one of the high-voltage components is faulty. When the energy management system determines that the low-voltage components and high-voltage components in the to-be-monitored components are all free from faults, the energy storage system is in a normal operating state. In this case, the insulation monitoring module obtains the insulation parameter value of the entire energy storage system, and sends the insulation parameter value of the energy storage system to the energy management system. Based on the insulation parameter value of the energy storage system, the energy management system may determine the insulation state of the energy storage system during normal operation, and check whether the energy storage system has passed the insulation state detection, so as to determine whether the energy storage system is faulty during normal operation.

In the above insulation state detection method, the power-up and power-down sequence of the to-be-monitored components is divided into a low-voltage power-up state and a high-voltage power-up sequence of the to-be-monitored components. In this way, when the insulation monitoring module detects the insulation state of each to-be-monitored component and the energy storage system, the detection logic can be as detailed as the low-voltage power-up state of each to-be-monitored component and the high-voltage power-up sequence of the high-voltage components in all the to-be-monitored components. The power-up sequence of the energy storage system itself is to power up the low-voltage components first and then power up the high-voltage components. This power-up sequence is equivalent to a power-up and power-down sequence that is set with reference to the power-up requirements of the components in the energy storage system, thereby improving the reliability in detecting the insulation state of each to-be-monitored component and the energy storage system. In some exemplary embodiments, the high-voltage power-up sequence is a sequence for high-voltage components. Therefore, the high-voltage components are sequentially powered up with a high voltage in specified order, thereby enabling the insulation monitoring module to detect the insulation state of the high-voltage components in an orderly manner, and reducing the number of interactions in detecting the insulation state of the high-voltage components. This can not only reduce the complexity of detecting the insulation state of the high-voltage components, but also greatly shorten the detection time for the insulation state of the high-voltage components, and improve the detection efficiency of the insulation state.

On the basis of the above embodiment, the following embodiment describes the details of "detecting, by the insulation monitoring module, the insulation state of each to-be-monitored component and the energy storage system sequentially based on the low-voltage power-up state of each to-be-monitored component and the high-voltage power-up sequence of the high-voltage components in all the to-be-monitored components" in step S202 in the embodiment shown in FIG. 4. As shown in FIG. 5, step S202 may include the following steps:
S301: Detecting, by the insulation monitoring module, the insulation state of a low-voltage component in all the to-be-monitored components after a low voltage is applied to all the to-be-monitored components.

In this embodiment, when the MPPT controller or the power grid provides a low voltage to the direct-current bus, the insulation monitoring module obtains the insulation parameter value of each to-be-monitored component, and sends the obtained insulation parameter value to the energy management system. Based on the insulation parameter value, the energy management system determines whether each to-be-monitored component is in a low-voltage power-up state. After determining that each to-be-monitored component is in the low-voltage power-up state, the energy management system further determines the insulation state of the low-voltage component based on the insulation parameter value. For example, when the insulation parameter value falls within a preset resistance range, the energy management system determines that the low-voltage component has passed the insulation state detection, that is, no fault occurs in the low-voltage component. When the insulation parameter value does not fall within the preset resistance range, the energy management system determines that the low-voltage component fails the insulation state detection, that is, a fault occurs in the low-voltage component.

S302: Detecting, by the insulation monitoring module, the insulation state of each high-voltage component and the energy storage system based on the high-voltage power-up sequence of the high-voltage components in all the to-be-monitored components in a case that all the low-voltage components have passed the insulation state detection.

When the low-voltage components have passed the insulation state detection and it is determined that the low-voltage components are free from the insulation fault, the energy management system needs to detect the insulation state of each high-voltage component in all the to-be-monitored components, so as to determine whether an insulation fault occurs in the high-voltage components.

In this embodiment, for each high-voltage component, when the energy management system controls the high-voltage component to get powered up with a high voltage, the insulation monitoring module may obtain the insulation parameter value of the high-voltage component and send the insulation parameter value to the energy management system. Upon receiving the insulation parameter value, the energy management system detects the insulation state of the high-voltage component. In this way, the insulation state of each high-voltage component can be detected. During the detection by the insulation monitoring module, the value detected is an insulation parameter value common to the high-voltage component and the direct-current bus. Based on this insulation parameter value, the insulation monitoring module determines the insulation state of the high-voltage component and the direct-current bus, that is, determines whether the low-voltage component or the direct-current bus is faulty. In some exemplary embodiments, due to a small resistance of the direct-current bus, it is just necessary to determine whether the high-voltage component is faulty, without considering the direct-current bus.

Understandable, in a process of detecting the insulation state of each high-voltage component, if one or more high-voltage components fail the insulation state detection, the corresponding high-voltage component incurs an insulation fault. In order to detect the insulation states of all high-voltage components, regardless of whether any one of the high-voltage components monitored before the current high-voltage component is faulty, it is necessary to control the current high-voltage component to undergo insulation state detection, so as to determine whether an insulation fault occurs in any one of the high-voltage components and determine the specific high-voltage component that incurs the insulation fault.

In some exemplary embodiments, when all the high-voltage components in all the to-be-monitored components have been powered up with a high voltage, and when none of the to-be-monitored components is faulty, the energy storage system is in a normal operating state. In this case, the insulation monitoring module may obtain the insulation parameter value of the entire energy storage system, and sends the insulation parameter value of the energy storage system to the energy management system. Based on the insulation parameter value, the energy management system determines the insulation state of the energy storage system, so as to determine whether a to-be-monitored component in the energy storage system is faulty when the energy storage system is operating normally.

In the above insulation state detection method, after a low voltage is applied to each to-be-monitored component, the insulation monitoring module detects the insulation state of the low-voltage components in the to-be-monitored components. In a case that all the low-voltage components have passed the insulation state detection, the insulation monitoring module detects the insulation state of each high-voltage component and the energy storage system based on the high-voltage power-up sequence of the high-voltage components in all the to-be-monitored components. This application divides the power-up process into low-voltage power-up and high-voltage power-up. The to-be-monitored components are correspondingly divided into low-voltage components and high-voltage components. In a process of low-voltage power-up and high-voltage power-up, the insulation monitoring module detects the insulation state of the low-voltage components and the high-voltage components sequentially, thereby determining an overall detection result of the insulation states of the low-voltage components and an overall detection result of the insulation states of the high-voltage components in all the to-be-monitored components. Further, in some exemplary embodiments, based on the high-voltage power-up sequence of the high-voltage components, the insulation monitoring module detects the insulation states of a plurality of high-voltage components in the to-be-monitored components, thereby reducing the number of interactions of the to-be-monitored components during the insulation state detection in the low-voltage power-up process and the high-voltage power-up process, and further reducing the complexity of the detection process of each to-be-monitored component.

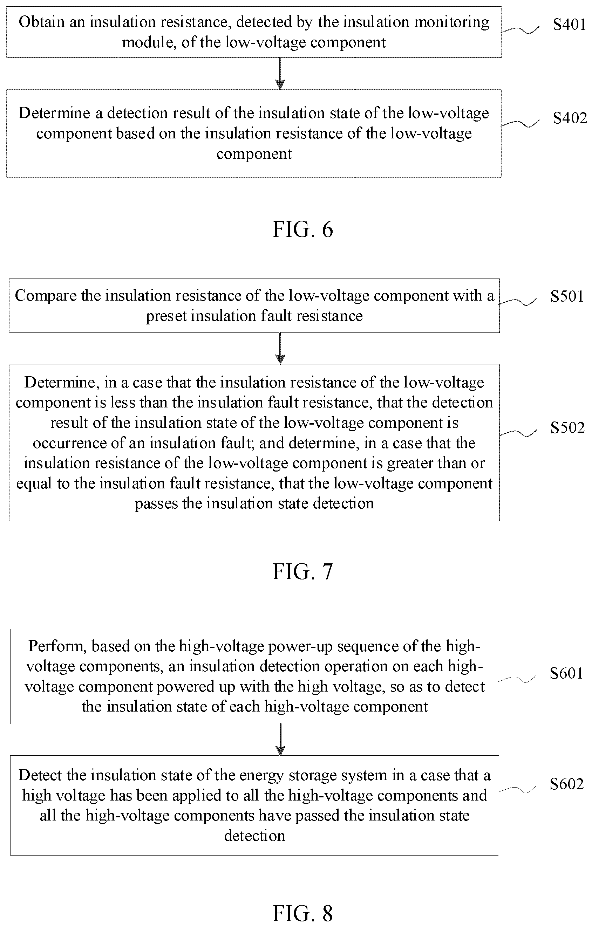

On the basis of the above embodiment, the following embodiment describes the details of "detecting, by the insulation monitoring module, the insulation state of a low-voltage component in all the to-be-monitored components" in step S301 in the embodiment shown in FIG. 5. As shown in FIG. 6, step S301 may include the following steps:
S401: Obtaining an insulation resistance, detected by the insulation monitoring module, of the low-voltage component.

The insulation resistance of the low-voltage component means a direct-current resistance of the low-voltage component in a low-voltage power-up state.

In this embodiment, the low-voltage components in the to-be-monitored components of the energy storage system may include an MPPT controller and a direct-current side device of the PCS. During a low-voltage power-up operation performed on each to-be-monitored component, the insulation resistance detected by the insulation monitoring module is an insulation resistance common to the MPPT controller and the direct-current side device of the PCS. The insulation monitoring module sends the detected insulation resistance to the energy management system, so that the energy management system can obtain the insulation resistance of the low-voltage component.

S402: Determining a detection result of the insulation state of the low-voltage component based on the insulation resistance of the low-voltage component.

In some exemplary embodiments, the energy management system may determine whether the insulation resistance of a low-voltage component falls within a preset range. If the insulation resistance falls within the preset range, the energy management system determines that the detection result of the insulation state of the low-voltage component is that the detection is passed, that is, no fault occurs in the low-voltage component. If the insulation resistance does not fall within the preset range, the energy management system determines that the detection result of the insulation state of the low-voltage component is that the detection is failed, that is, a fault occurs in the low-voltage component. In some exemplary embodiments, the energy management system compares the insulation resistance of the low-voltage component with a preset resistance, and determines the detection result of the insulation state of the low-voltage component based on the comparison result. In some exemplary embodiments, the energy management system may calculate an error value between the insulation resistance of the low-voltage component and the preset resistance, and determine the detection result of the insulation state of the low-voltage component based on the error value and a preset error value. The method for determining the detection result of the insulation state based on the insulation resistance of the low-voltage component is not particularly limited herein.

In the above insulation state detection method, when monitoring a low-voltage component, the insulation monitoring module does not need to distinguish a specific low-voltage component. The insulation monitoring module can quickly detect the insulation resistances of all the low-voltage components. After obtaining the insulation resistances of the low-voltage components in time, the insulation monitoring module can analyze the insulation resistances of the low-voltage components, thereby determining the detection result of the insulation state of the low-voltage components quickly, and improving the efficiency of the insulation detection of the low-voltage components.

In some exemplary embodiments, this embodiment describes the details of "determining a detection result of the insulation state of the low-voltage component based on the insulation resistance of the low-voltage component" in step S402 in the embodiment shown in FIG. 6. As shown in FIG. 7, step S402 may include the following steps:
S501: Comparing the insulation resistance of the low-voltage component with a preset insulation fault resistance.

In this embodiment, the preset insulation fault resistance may be determined based on a large amount of historical insulation fault data, or determined based on the actual operating properties of the energy storage system. The preset insulation fault resistance is stored in the database of the energy management system. The preset insulation fault resistance is a boundary. The insulation resistances located on one side of the insulation fault resistance are normal resistances, and represent normal operation of the low-voltage component. The insulation resistances located on the other side of the insulation fault resistance are abnormal resistances, and represent an insulation fault in the low-voltage component. Upon obtaining the insulation resistance of the low-voltage component, the energy management system compares the insulation resistance with the preset insulation fault resistance to determine whether an insulation fault occurs in the low-voltage component.

S502: Determining, in a case that the insulation resistance of the low-voltage component is less than the insulation fault resistance, that the detection result of the insulation state of the low-voltage component is occurrence of an insulation fault; or, determining, in a case that the insulation resistance of the low-voltage component is greater than or equal to the insulation fault resistance, that the low-voltage component passes the insulation state detection.

In this embodiment, the greater the insulation resistance of the low-voltage component, the better the insulation effect of the low-voltage component. Correspondingly, the smaller the insulation resistance of the low-voltage component, the worse the insulation effect of the low-voltage component. When the insulation resistance of the low-voltage component is less than the insulation fault resistance, it indicates that an insulation fault occurs in some or all of the low-voltage components. However, based on the insulation resistance and the insulation fault resistance of the low-voltage component, it is uncertain which specific low-voltage component is faulty. In this case, a technician needs to troubleshoot all the low-voltage components to determine the specific low-voltage component that is faulty. When the insulation resistance of the low-voltage component is greater than or equal to the insulation fault resistance, that is, when the low-voltage component passes the insulation state detection, it indicates that all the low-voltage components are free from the insulation fault, and the low-voltage components are operating normally.

In the above insulation state detection method, the insulation resistance of the low-voltage component is compared with the preset insulation fault resistance. In the case that the insulation resistance of the low-voltage component is less than the insulation fault resistance, it is determined that the detection result of the insulation state of the low-voltage component is occurrence of an insulation fault. In the case that the insulation resistance of the low-voltage component is greater than or equal to the insulation fault resistance, it is determined that the low-voltage component passes the insulation state detection. Based on the result of comparison between the insulation resistance of the low-voltage component and the preset insulation fault resistance, the detection result of the insulation state of the low-voltage component can be determined accurately, thereby accurately determining whether an insulation fault occurs in the low-voltage component.

On the basis of the above embodiment, the following embodiment describes the details of "detecting, by the insulation monitoring module, the insulation state of each high-voltage component and the energy storage system based on the high-voltage power-up sequence of the high-voltage components in all the to-be-monitored components" in step S302 in the embodiment shown in FIG. 5. As shown in FIG. 8, step S302 may include the following steps:
S601: Performing, based on the high-voltage power-up sequence of the high-voltage components, an insulation detection operation on each high-voltage component powered up with the high voltage, so as to detect the insulation state of each high-voltage component.

In this embodiment, the energy management system may power up each high-voltage component by use of a high voltage based on the high-voltage power-up sequence. In powering up each high-voltage component by use of a high voltage, the insulation monitoring module may detect the insulation parameter value of each high-voltage component that has been powered up with a high voltage, and send the insulation parameter value to the energy management system. Based on the insulation parameter value, the energy management system determines whether the high-voltage component passes the insulation state detection. For example, if the high-voltage power-up sequence of the high-voltage components is from the BMS in the electric cabinet to the direct-current chopper in the electric cabinet, and then to the inverter in the PCS, then based on this high-voltage power-up sequence, the energy management system first controls the BMS in the electric cabinet to get powered up with a high voltage. After the BMS in the electric cabinet is powered up with a high voltage, because the BMS in the electric cabinet is connected to the direct-current chopper in the electric cabinet, and the electric cabinet formed of the BMS and the direct-current chopper is connected to the direct-current bus in parallel, the insulation monitoring module is unable to obtain the insulation parameter value of the BMS in the electric cabinet. After the BMS is powered up with a high voltage, the energy management system controls the direct-current chopper in the electric cabinet to get powered up with a high voltage. After the direct-current chopper is powered up with a high voltage, the insulation monitoring module obtains the insulation parameter value common to the BMS and the direct-current chopper in the electric cabinet, and sends the insulation parameter value to the energy management system. Based on the insulation parameter value, the energy management system determines whether the electric cabinet passes the insulation state detection. Finally, the energy management system controls the inverter in the PCS to get powered up with a high voltage. After the inverter is powered up with a high voltage, the insulation monitoring module obtains the insulation parameter value of the inverter, and sends the insulation parameter value to the energy management system. Based on the insulation parameter value of the inverter, the energy management system determines whether the inverter passes the insulation state detection.

S602: Detecting the insulation state of the energy storage system in a case that a high voltage has been applied to all the high-voltage components and all the high-voltage components have passed the insulation state detection.

In this embodiment, in the process of powering up each high-voltage component by using a high voltage, if a high-voltage component fails the insulation state detection, the corresponding energy storage system also fails the insulation state detection. If the insulation detection results show that all the high-voltage components have passed the detection, it is determined that the low-voltage components and high-voltage components in all the to-be-monitored component are normal. In this case, the energy management system needs to determine whether an insulation fault occurs in the energy storage system in normal operation after the high voltage is applied to all the high-voltage components, so as to ensure the normal operation of the energy storage system.

In some exemplary embodiments, after the high voltage is applied to all the high-voltage components and the energy storage system operates normally, the insulation monitoring module obtains the insulation parameter values of the to-be-monitored components in the energy storage system and sends the insulation parameter values to the energy management system. Based on the insulation parameter values, the energy management system determines whether the energy storage system has passed insulation state detection during normal operation of the energy storage system. If the energy storage system has passed the insulation state detection, it indicates that all the to-be-monitored components inside the energy storage system are free from faults, and the entire energy storage system is operating normally, and the insulation detection process ends. If the energy storage system fails the insulation state detection, it indicates that a to-be-monitored component inside the energy storage system is faulty during operation. In this case, it is necessary to disconnect all components in the energy storage system from the high voltage first, and then, based on the high-voltage power-up sequence, check whether a fault occurs in any of the to-be-monitored components inside the energy storage system. Alternatively, a technician manually checks whether a fault occurs in any of the to-be-monitored components.

In the above insulation state detection method, in a process of powering up each high-voltage component with a high voltage based on the high-voltage power-up sequence of the high-voltage components, the high-voltage power-up time of each high-voltage component is relatively short. Therefore, in a process of powering up each high-voltage component with a high voltage for a number of times, the time taken for the insulation monitoring module to perform insulation detection on the high-voltage component is also relatively short. In addition, the insulation resistance corresponding to each high-voltage component can be obtained through one insulation monitoring module. If all the high-voltage components have been powered up with a high voltage and have passed the insulation state detection, the insulation monitoring module can accurately detect the insulation state of the energy storage system. In this process, the insulation resistance of each high-voltage component is detected in real time by one insulation monitoring module, thereby reducing the number of interactions in the detection process, reducing the complexity of the detection process of the high-voltage component, avoiding repeated turning on and off of the insulation monitoring module, and improving the detection efficiency of the insulation monitoring module.

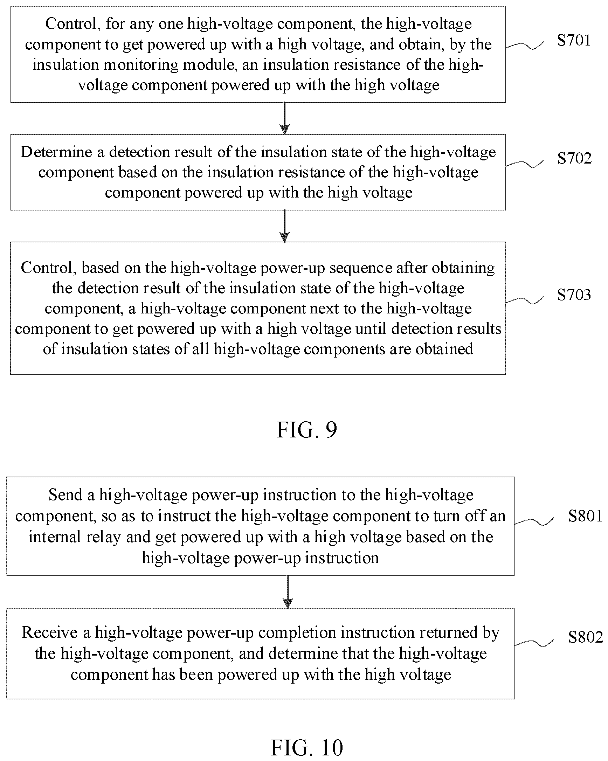

On the basis of the above embodiment, the following embodiment describes the details of "performing an insulation detection operation on each high-voltage component powered up with a high voltage" in step S601 in the embodiment shown in FIG. 8. As shown in FIG. 9, step S601 may include the following steps:
S701: Controlling, for any one high-voltage component, the high-voltage component to get powered up with a high voltage, and obtaining, by the insulation monitoring module, an insulation resistance of the high-voltage component powered up with the high voltage.

In this embodiment, the high-voltage components in all the to-be-monitored components are powered up with a high voltage based on the high-voltage power-up sequence of the high-voltage components. For each high-voltage component, the energy management system sends a high-voltage power-up instruction to the high-voltage component. Upon receiving the high-voltage power-up instruction, the high-voltage component turns off the relay inside the high-voltage component, and the high-voltage component completes the high-voltage power-up operation. The insulation monitoring module can promptly obtain the insulation resistance of the high-voltage component powered up with the high voltage.

S702: Determining a detection result of the insulation state of the high-voltage component based on the insulation resistance of the high-voltage component powered up with the high voltage.

In this embodiment, the energy management system determines whether the insulation resistance of the high-voltage component powered up with the high voltage meets a preset condition, and, based on the determining result, determines a detection result of the insulation state of the high-voltage component. For example, the preset condition may be a preset insulation range, a preset insulation threshold, or an error value between the insulation resistance of the high-voltage component and the preset resistance. When the preset condition is a preset insulation range, the energy management system determines whether the insulation resistance of the high-voltage component falls within the preset insulation range, and, based on the determining result, determines a detection result of the insulation state of the high-voltage component. When the preset condition is a preset insulation threshold, the energy management system compares the insulation resistance of the high-voltage component with the preset insulation resistance, and, based on the comparison result, determines a detection result of the insulation state of the high-voltage component. When the preset condition is an error value between the insulation resistance of the high-voltage component and a preset resistance, the energy management system may calculate an error value between the insulation resistance of the high-voltage component and the preset resistance, and determine a detection result of the insulation state of the high-voltage component based on the error value and a preset error value.

S703: Controlling, based on the high-voltage power-up sequence after obtaining the detection result of the insulation state of the high-voltage component, a high-voltage component next to the high-voltage component to get powered up with a high voltage until detection results of insulation states of all high-voltage components are obtained.

In this embodiment, if the insulation resistance meets the preset condition, it is determined that the high-voltage component has passed the insulation state detection, that is, no fault occurs in the high-voltage component. If the insulation resistance does not fall within the preset range, it is determined that the high-voltage component fails the insulation state detection, that is, a fault occurs in the high-voltage component.

Understandably, regardless of whether the high-voltage component passes or fails the insulation state detection, after obtaining the detection result of the insulation state of the high-voltage component, the energy management system controls a next high-voltage component to undergo a high-voltage power-up operation based on the high-voltage power-up sequence, and determines a detection result of the insulation state of the next high-voltage component, that is, determines whether the next high-voltage component incurs an insulation fault. Similarly, the energy management system determines the detection result of the insulation state of each high-voltage component sequentially according to the above method, so as to determine whether an insulation fault occurs in any one of the high-voltage components.

In the above insulation state detection method, for any one high-voltage component, the high-voltage component is controlled to be powered up with a high voltage, and the insulation monitoring module obtains the insulation resistance of the high-voltage component that has been powered up with a high voltage. The detection result of the insulation state of the high-voltage component can be determined based on the insulation resistance of the high-voltage component that has been powered up with a high voltage. If the high-voltage component passes the insulation state detection, a high-voltage component next to the high-voltage component is controlled to be powered up with a high voltage based on the high-voltage power-up sequence until the detection results of insulation states of all the high-voltage components are obtained. The insulation states of the high-voltage components are detected in an iterative manner, so that the detection process for the high-voltage components is more standardized, thereby achieving a more accurate detection result of the insulation state of the high-voltage component. In addition, all the high-voltage components are monitored in real time by one insulation monitoring module, thereby reducing the detection cost, reducing the number of interactions in the detection process, and reducing the interaction complexity.

On the basis of the above embodiment, the following embodiment describes the details of "controlling the high-voltage component to get powered up with a high voltage" in step S701 in the embodiment shown in FIG. 9. As shown in FIG. 10, step S701 may include the following steps:
S801: Sending a high-voltage power-up instruction to the high-voltage component, so as to instruct the high-voltage component to turn off an internal relay and get powered up with a high voltage based on the high-voltage power-up instruction.

In this embodiment, the energy management system is communicatively connected to each high-voltage component. When the high-voltage components need to be powered up with a high voltage sequentially, for each high-voltage component, the energy management system sends a high-voltage power-up instruction to the high-voltage component. Upon receiving the high-voltage power-up instruction, the high-voltage component turns off the relay inside the high-voltage component, and the high-voltage component completes the high-voltage power-up operation.

S802: Receiving a high-voltage power-up completion instruction returned by the high-voltage component, and determining that the high-voltage component has been powered up with the high voltage.

In this embodiment, after sending the high-voltage power-up instruction to the high-voltage component, if the energy management system receives a high-voltage power-up completion instruction returned by the high-voltage component within a preset time, the energy management system determines that the high-voltage component has received the high-voltage power-up instruction. In some exemplary embodiments, the energy management system determines that the high-voltage component has completed the operation of being powered up with the high voltage based on the received high-voltage power-up instruction, so as to be ready to send a high-voltage power-up instruction to a next high-voltage component based on the high-voltage power-up sequence.

In the above insulation state detection method, a high-voltage power-up instruction is sent to the high-voltage component to instruct the high-voltage component to turn off the internal relay and complete the high-voltage power-up based on the high-voltage power-up instruction. After the high-voltage component is powered up with a high voltage, a high-voltage power-up completion instruction returned by the high-voltage component is received. For each high-voltage component, by sending the high-voltage power-up instruction and receiving the high-voltage power-up completion instruction, this application can apply a high voltage to each high-voltage component based on the high-voltage power-up sequence of the high-voltage components, thereby avoiding disorder of the high-voltage power-up process of the high-voltage components. In a process of monitoring the high-voltage components, the insulation monitoring module does not need to be frequently turned on or off, thereby reducing the number of interactions in the detection process, and reducing the complexity of the detection process for the high-voltage components.

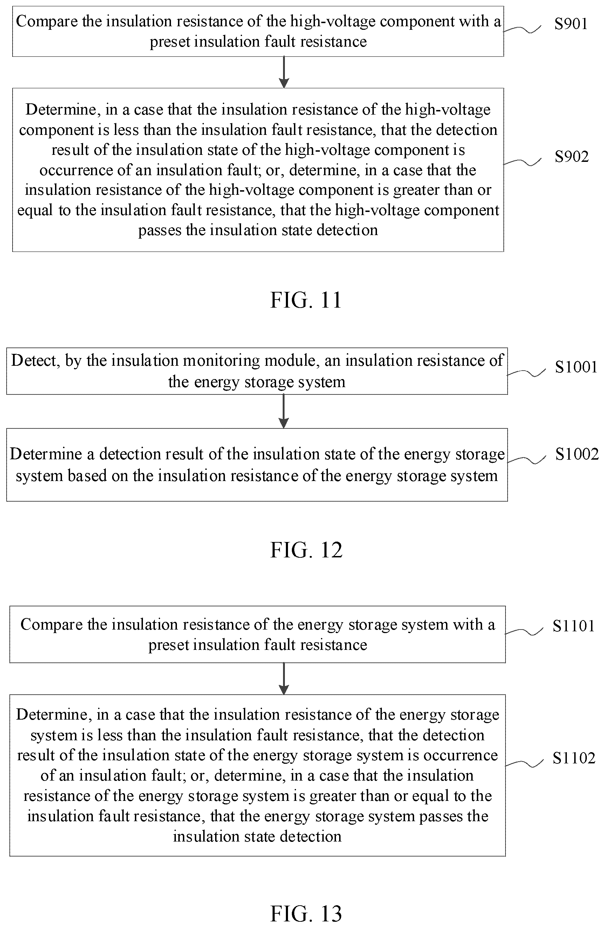

On the basis of the above embodiment, the following embodiment describes the details of "determining a detection result of the insulation state of the high-voltage component based on the insulation resistance of the high-voltage component powered up with the high voltage" in step S702 in the embodiment shown in FIG. 9. As shown in FIG. 11, step S702 may include the following steps:
S901: Comparing the insulation resistance of the high-voltage component with a preset insulation fault resistance.

In this embodiment, the preset insulation fault resistance is a boundary. The insulation resistances located on one side of the insulation fault resistance are normal resistances, and represent normal operation of the high-voltage component. The insulation resistances located on the other side of the insulation fault resistance are abnormal resistances, and represent an insulation fault in the high-voltage component. Upon obtaining the insulation resistance of the high-voltage component, the energy management system compares the insulation resistance with the preset insulation fault resistance to determine whether an insulation fault occurs in the high-voltage component.

S902: Determining, in a case that the insulation resistance of the high-voltage component is less than the insulation fault resistance, that the detection result of the insulation state of the high-voltage component is occurrence of an insulation fault; or, determining, in a case that the insulation resistance of the high-voltage component is greater than or equal to the insulation fault resistance, that the high-voltage component passes the insulation state detection.

In this embodiment, in a case that the insulation resistance of the high-voltage component is less than the insulation fault resistance, it indicates that an insulation fault occurs in the high-voltage component. In a case that the insulation resistance of the high-voltage component is greater than or equal to the insulation fault resistance, the high-voltage component passes the insulation state detection, and the high-voltage component is free from the insulation fault.

In the above insulation state detection method, the insulation resistance of the high-voltage component is compared with the preset insulation fault resistance. In the case that the insulation resistance of the high-voltage component is less than the insulation fault resistance, it is determined that the detection result of the insulation state of the high-voltage component is occurrence of an insulation fault. In the case that the insulation resistance of the high-voltage component is greater than or equal to the insulation fault resistance, it is determined that the high-voltage component passes the insulation state detection. Based on the result of comparison between the insulation resistance of the high-voltage component and the preset insulation fault resistance, the detection result of the insulation state of the high-voltage component can be determined accurately, thereby accurately determining whether an insulation fault occurs in the high-voltage component.

On the basis of the above embodiment, the following embodiment describes the details of "detecting the insulation state of the energy storage system" in step S602 in the embodiment shown in FIG. 8. As shown in FIG. 12, step S602 may include the following steps:
S1001: Detecting, by the insulation monitoring module, an insulation resistance of the energy storage system.

In this embodiment, after all the low-voltage components are powered up with a low voltage and all the high-voltage components are powered up with a high voltage in all the to-be-monitored components, if the low-voltage components and the high-voltage components are all free from insulation faults, the energy storage system is in a high-voltage normal operating state. In this case, the insulation monitoring module may obtain an insulation resistance of the entire energy storage system, and sends the insulation resistance of the energy storage system to the energy management system, so that the energy management system obtains the insulation resistance of the energy storage system detected by the insulation monitoring module.

S1002: Determining a detection result of the insulation state of the energy storage system based on the insulation resistance of the energy storage system.

In this embodiment, the energy management system determines whether the insulation resistance of the energy storage system meets a preset condition, and, based on the determining result, determines a detection result of the insulation state of the energy storage system. For example, the preset condition may be a preset insulation range, a preset insulation threshold, or an error value between the insulation resistance of the energy storage system and the preset resistance. When the preset condition is a preset insulation range, the energy management system determines whether the insulation resistance of the energy storage system falls within the preset insulation range, and, based on the determining result, determines a detection result of the insulation state of the energy storage system. When the preset condition is a preset insulation threshold, the energy management system compares the insulation resistance of the energy storage system with the preset insulation resistance, and, based on the comparison result, determines a detection result of the insulation state of the energy storage system.

In the above insulation state detection method, when the insulation monitoring module monitors the energy storage system, it is necessary to specifically distinguish the energy storage system. The insulation resistance of the entire energy storage system can be detected by the insulation monitoring module, thereby quickly determining whether an insulation fault occurs in the energy storage system in normal operation. In addition, one insulation monitoring module can not only monitor all the to-be-monitored components, but also monitor the entire energy storage system, thereby reducing the hardware cost in the insulation detection for the energy storage system.

On the basis of the above embodiment, the following embodiment describes the details of "determining a detection result of the insulation state of the energy storage system based on the insulation resistance of the energy storage system" in step S1002 in the embodiment shown in FIG. 12. As shown in FIG. 13, step S1002 may include the following steps:
S1101: Comparing the insulation resistance of the energy storage system with a preset insulation fault resistance.

In this embodiment, the preset insulation fault resistance is a boundary. The insulation resistances located on one side of the insulation fault resistance are normal resistances, and represent normal operation of the energy storage system. The insulation resistances located on the other side of the insulation fault resistance are abnormal resistances, and represent an insulation fault in the energy storage system. Upon obtaining the insulation resistance of the energy storage system, the energy management system compares the insulation resistance with the preset insulation fault resistance to determine whether an insulation fault occurs in the energy storage system.

S1102: Determining, in a case that the insulation resistance of the energy storage system is less than the insulation fault resistance, that the detection result of the insulation state of the energy storage system is occurrence of an insulation fault; or, determining, in a case that the insulation resistance of the energy storage system is greater than or equal to the insulation fault resistance, that the energy storage system passes the insulation state detection.

In this embodiment, when the insulation resistance of the energy storage system is less than the insulation fault resistance, it indicates that an insulation fault occurs in a to-be-monitored component in the energy storage system during normal operation of the energy storage system, but it is uncertain which to-be-monitored component incurs the insulation fault. It is necessary to troubleshoot the to-be-monitored components in the energy storage system again in a low-voltage and high-voltage manner. When the insulation resistance of the energy storage system is greater than or equal to the insulation fault resistance, that is, when the energy storage system passes the insulation state detection, it indicates that the energy storage system is free from the insulation fault, and the energy storage system is operating normally.

In the above insulation state detection method, the insulation resistance of the energy storage system is compared with the preset insulation fault resistance. In the case that the insulation resistance of the energy storage system is less than the insulation fault resistance, it is determined that the detection result of the insulation state of the energy storage system is occurrence of an insulation fault. In the case that the insulation resistance of the energy storage system is greater than or equal to the insulation fault resistance, it is determined that the energy storage system passes the insulation state detection. Based on the result of comparison between the insulation resistance of the energy storage system and the preset insulation fault resistance, the detection result of the insulation state of the energy storage system can be determined accurately, thereby accurately determining whether an insulation fault occurs in the energy storage system.

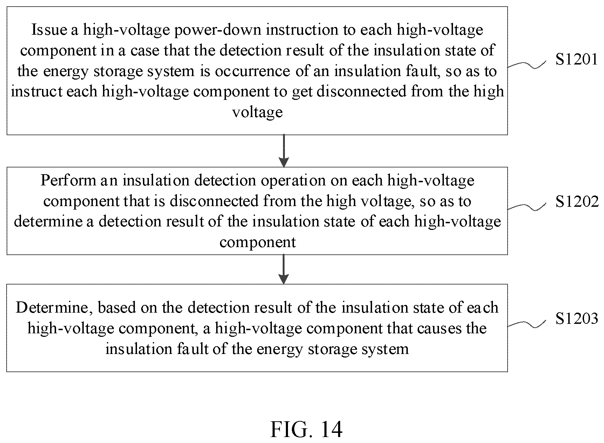

On the basis of the above embodiment, the following embodiment describes the details of troubleshooting the to-be-monitored components in the energy storage system that incurs an insulation fault indicated by the detection result of the insulation state of the energy storage system. As shown in FIG. 14, the method may further include the following steps:
S1201: Issuing a high-voltage power-down instruction to each high-voltage component in a case that the detection result of the insulation state of the energy storage system is occurrence of an insulation fault, so as to instruct each high-voltage component to get disconnected from the high voltage.

In this embodiment, after all the high-voltage components are powered up with a high voltage, when the energy storage system is in normal operation, if the insulation resistance obtained by the insulation monitoring module is less than a preset insulation fault resistance, then a to-be-monitored component in the energy storage system in normal operation incurs an insulation fault. The energy management system may send a high-voltage power-down instruction to the high-voltage components in the to-be-monitored components simultaneously, or, the energy management system may send the high-voltage power-down instruction to the high-voltage components sequentially based on the high-voltage power-down sequence of the high-voltage components. Upon receiving the high-voltage power-down instruction, each high-voltage component performs a high-voltage power-down operation based on the high-voltage power-down instruction.

S1202: Performing an insulation detection operation on each high-voltage component after the high-voltage component is disconnected from the high voltage, so as to determine a detection result of the insulation state of each high-voltage component.

In this embodiment, after performing the high-voltage power-down operation, each high-voltage component returns a high-voltage power-down completion instruction to the energy management system. At this time, each to-be-monitored component in the energy storage system is in a low-voltage state. After detecting the insulation resistance of a low-voltage component, the insulation monitoring module sends the insulation resistance to the energy management system. Based on the insulation resistance of the low-voltage component, the energy management system determines whether an insulation fault occurs in the low-voltage component. When it is determined that all the low-voltage components are free from insulation faults, the energy management system controls the high-voltage components to undergo a high-voltage power-up operation sequentially. The insulation monitoring module detects the insulation resistance of each high-voltage component. The detection result of the insulation state of each high-voltage component is determined based on the insulation resistance of each high-voltage component.

S1203: Determining, based on the detection result of the insulation state of each high-voltage component, a high-voltage component that causes the insulation fault of the energy storage system.

In this embodiment, during the insulation state detection of the high-voltage components, if any one or more of the high-voltage components fail the insulation state detection, it is determined that the high-voltage component corresponding to the failure of the insulation state detection incurs an insulation fault. In other words, the high-voltage component is free from the insulation fault during the high-voltage power-up test, but incurs an insulation fault during normal operation of the energy storage system.

In the above insulation state detection method, if the detection result of the insulation state of the energy storage system is occurrence of an insulation fault, it means that an insulation fault occurs during normal operation of the energy storage system, but without determining the to-be-monitored component on which the insulation fault occurs in the energy storage system. A high-voltage power-down instruction is issued to all the high-voltage components to instruct all the high-voltage components to be disconnected from the high voltage. After all the high-voltage components are disconnected from the high voltage, it is ensured that all the to-be-monitored components are in a low-voltage state, so as to determine whether an insulation fault occurs in the low-voltage components. If no insulation fault occurs in any low-voltage component, an insulation detection operation is performed on each high-voltage component powered up with the high voltage, so as to obtain an insulation resistance corresponding to each high-voltage component. In this way, all the high-voltage components are accurately troubleshot based on the insulation resistance, so as to determine a detection result of the insulation state of each high-voltage component. Based on the detection result of the insulation state of each high-voltage component, the high-voltage component that causes the insulation fault of the energy storage system can be accurately determined, thereby improving the accuracy of insulation state detection.

On the basis of the above embodiment, the following embodiment describes the details of turning on the insulation monitoring module. The above method may further include: sending an insulation detection start instruction to the insulation monitoring module in a case that each to-be-monitored component is powered up with a low voltage, where the insulation detection start instruction is used for switching the insulation monitoring module to the on-state.

In this embodiment, after determining that each to-be-monitored component is powered up with a low voltage, the energy management system may send an insulation detection start instruction to the insulation monitoring module. The insulation detection start instruction is used for instructing the insulation monitoring module to switch from the off-state to the on-state and detect the insulation resistance of each to-be-monitored component.

In the above insulation state detection method, upon detecting that a to-be-monitored component is powered up with a low voltage, an insulation detection start instruction is promptly sent to the insulation monitoring module, so that the insulation monitoring module is switched to the on-state. The insulation monitoring module stays in the on-state without being automatically turned off. In the entire process, the insulation monitoring module can detect the insulation resistance of each to-be-monitored component in real time, thereby preventing the insulation monitoring module from being turned on or off repeatedly, reducing the number of interactions in the detection process, and reducing the complexity of interactions in the detection process.

On the basis of the above embodiment, the following embodiment describes the details of prompting troubleshooting and repair of the to-be-monitored components when an insulation fault occurs. The above method may further include: outputting a prompt message for any one to-be-monitored component in a case that the detection result of the insulation state of the to-be-monitored component is occurrence of an insulation fault, where the prompt message is used for instructing the to-be-monitored component to get troubleshot and repaired to remove the insulation fault.

In this embodiment, when it is determined that any one of the to-be-monitored components in the energy storage system incurs an insulation fault, the energy management system outputs a prompt message to a technician. The prompt message indicates a specific to-be-monitored component and indicates whether the insulation fault of the to-be-monitored component is detected during the power-up or the insulation fault is detected during safe operation of the energy storage system. The prompt message may be output in the form of voice, text, or a combination of voice and text.

In the above insulation state detection method, for any one to-be-monitored component, if the detection result of the insulation state of the to-be-monitored component is occurrence of an insulation fault, a prompt message can be output to a technician in time. The technician can troubleshoot and repair the to-be-monitored component with respect to the insulation fault in time to ensure the safe operation of the energy storage system.

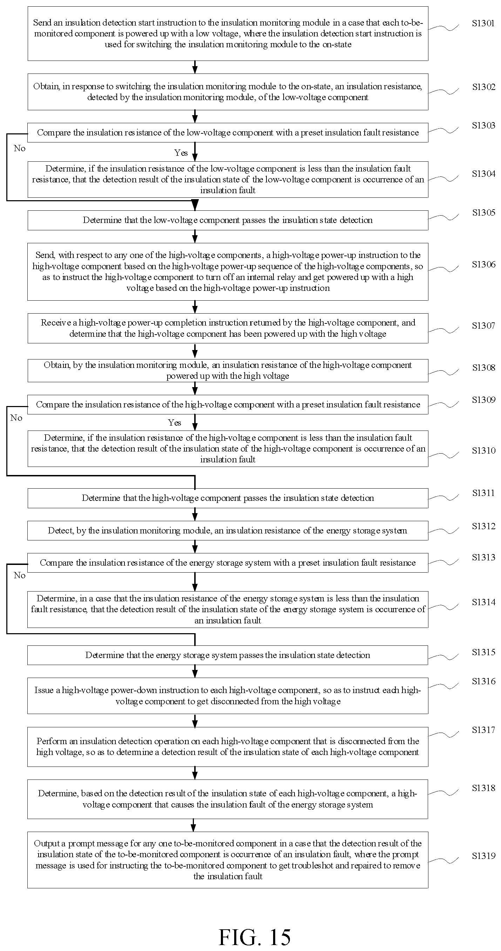

As shown in FIG. 15, another embodiment of an insulation state detection method is provided, including the following steps:
S1301: Sending an insulation detection start instruction to the insulation monitoring module in a case that each to-be-monitored component is powered up with a low voltage, where the insulation detection start instruction is used for switching the insulation monitoring module to the on-state.
S1302: Obtaining, in response to switching the insulation monitoring module to the on-state, an insulation resistance, detected by the insulation monitoring module, of the low-voltage component.
S1303: Comparing the insulation resistance of the low-voltage component with a preset insulation fault resistance.
S1304: Determining, if the insulation resistance of the low-voltage component is less than the insulation fault resistance, that the detection result of the insulation state of the low-voltage component is occurrence of an insulation fault.
S1305: Determining, if the insulation resistance of the low-voltage component is greater than or equal to the insulation fault resistance, that the low-voltage component passes the insulation state detection, and proceeding to step S1306.
S1306: Sending, with respect to any one of the high-voltage components, a high-voltage power-up instruction to the high-voltage component based on the high-voltage power-up sequence of the high-voltage components, so as to instruct the high-voltage component to turn off an internal relay and get powered up with a high voltage based on the high-voltage power-up instruction.
S1307: Receiving a high-voltage power-up completion instruction returned by the high-voltage component, and determining that the high-voltage component has been powered up with the high voltage.
S1308: Obtaining, by the insulation monitoring module, an insulation resistance of the high-voltage component powered up with the high voltage.
S1309: Comparing the insulation resistance of the high-voltage component with a preset insulation fault resistance.
S1310: Determining, if the insulation resistance of the high-voltage component is less than the insulation fault resistance, that the detection result of the insulation state of the high-voltage component is occurrence of an insulation fault.
S1311: Determining, if the insulation resistance of the high-voltage component is greater than or equal to the insulation fault resistance, that the high-voltage component passes the insulation state detection, and proceeding to step S1312.
S1312: Detecting, by the insulation monitoring module, an insulation resistance of the energy storage system.
S1313: Comparing the insulation resistance of the energy storage system with a preset insulation fault resistance.
S1314: Determining, if the insulation resistance of the energy storage system is less than the insulation fault resistance, that the detection result of the insulation state of the energy storage system is occurrence of an insulation fault, and proceeding to step S1316.
S1315: Determining, if the insulation resistance of the energy storage system is greater than or equal to the insulation fault resistance, that the energy storage system passes the insulation state detection.
S1316: Issuing a high-voltage power-down instruction to each high-voltage component, so as to instruct each high-voltage component to get disconnected from the high voltage.
S1317: Performing an insulation detection operation on each high-voltage component after the high-voltage component is disconnected from the high voltage, so as to determine a detection result of the insulation state of each high-voltage component.
S1318: Determining, based on the detection result of the insulation state of each high-voltage component, a high-voltage component that causes the insulation fault of the energy storage system.
S1319: Outputting a prompt message for any one to-be-monitored component in a case that the detection result of the insulation state of the to-be-monitored component is occurrence of an insulation fault, where the prompt message is used for instructing the to-be-monitored component to get troubleshot and repaired to remove the insulation fault.

In the above insulation state detection method, the energy management system is communicatively connected to a plurality of to-be-monitored components and one insulation monitoring module. In addition, all the to-be-monitored components and the insulation monitoring module are connected to the same direct-current bus in parallel. Such an arrangement makes the line connection relationship simple. During the insulation state detection, the insulation states of a plurality of to-be-monitored components and the energy storage system can be detected by just one insulation monitoring module, thereby reducing the hardware cost in the process of detecting the insulation state. Moreover, the insulation state of each to-be-monitored component and the energy storage system is detected with reference to the power-up and power-down sequence of the to-be-monitored components. In this way, on the basis of a simple line connection manner, the insulation state of each to-be-monitored component and the energy storage system can be detected in an orderly manner based on the preset the power-up and power-down sequence, thereby reducing the number of interactions in the detection process, simplifying the process of detecting the insulation fault of each to-be-monitored component and the energy storage system, and reducing the complexity of the process of detecting the insulation fault of the energy storage system.

Understandably, although the steps in a flowchart related to each of the above embodiments are sequentially displayed as indicated by arrows, the steps are not necessarily performed in the order indicated by the arrows. Unless otherwise expressly specified herein, the order of performing the steps is not strictly limited, and the steps may be performed in other order. Moreover, at least a part of the steps in the flowchart related to each embodiment described above may include a plurality of substeps or stages. The substeps or stages are not necessarily performed at the same time, but may be performed at different times. The substeps or stages are not necessarily performed sequentially, but may take turns with or alternate with other steps or at least a part of substeps or stages of other steps.

Based on the same inventive concept, an embodiment of this application further provides an insulation state detection apparatus for implementing the above insulation state detection method. The technical solution of this apparatus to solve the problems is similar to the technical solution described in the above method. Therefore, the specific definitions in one or more embodiments of the insulation state detection apparatus provided below may be learned with reference to the above definitions for the insulation state detection method, the details of which are omitted here.

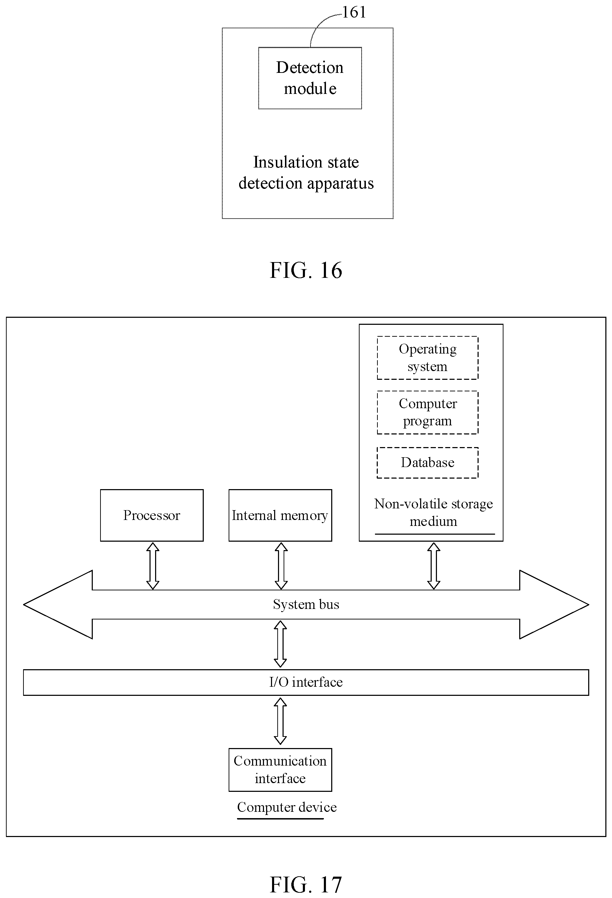

In an embodiment, an shown in FIG. 16, an insulation state detection apparatus is provided, including a detection module 161.

The detection module 161 is configured to: detect, by an insulation monitoring module in response to switching the insulation monitoring module to an on-state, an insulation state of each to-be-monitored component and an energy storage system sequentially based on a power-up and power-down sequence of the to-be-monitored components.

In an embodiment, the detection module 161 includes an obtaining unit and a detection unit.

The obtaining unit is configured to obtain the low-voltage power-up state of each to-be-monitored component and the high-voltage power-up sequence of high-voltage components in all the to-be-monitored components.

The detection unit is configured to detect, by the insulation monitoring module, the insulation state of each to-be-monitored component and the energy storage system sequentially based on the low-voltage power-up state of each to-be-monitored component and the high-voltage power-up sequence of the high-voltage components in all the to-be-monitored components.

In an embodiment, the detection unit detects the insulation state of a low-voltage component in all the to-be-monitored components by use of the insulation monitoring module after a low voltage is applied to all the to-be-monitored components.

The detection unit detects the insulation state of each high-voltage component and the energy storage system by use of the insulation monitoring module based on the high-voltage power-up sequence of the high-voltage components in all the to-be-monitored components in a case that all low-voltage components have passed the insulation state detection.

In an embodiment, the detection unit is further configured to:
obtain an insulation resistance, detected by the insulation monitoring module, of the low-voltage component; and
determine a detection result of the insulation state of the low-voltage component based on the insulation resistance of the low-voltage component.

In an embodiment, the detection unit is further configured to:
compare the insulation resistance of the low-voltage component with a preset insulation fault resistance;
determine, in a case that the insulation resistance of the low-voltage component is less than the insulation fault resistance, that the detection result of the insulation state of the low-voltage component is occurrence of an insulation fault; or, determine, in a case that the insulation resistance of the low-voltage component is greater than or equal to the insulation fault resistance, that the low-voltage component passes the insulation state detection.

In an embodiment, the detection unit is further configured to:
perform, based on the high-voltage power-up sequence of the high-voltage components, an insulation detection operation on each high-voltage component powered up with the high voltage, so as to detect the insulation state of each high-voltage component; and
detect the insulation state of the energy storage system in a case that a high voltage has been applied to all the high-voltage components and all the high-voltage components have passed the insulation state detection.

In an embodiment, for any one high-voltage component, the detection unit is further configured to:
control the high-voltage component to get powered up with a high voltage, and obtain, by the insulation monitoring module, an insulation resistance of the high-voltage component powered up with the high voltage;
determine a detection result of the insulation state of the high-voltage component based on the insulation resistance of the high-voltage component powered up with the high voltage; and
control, based on the high-voltage power-up sequence after obtaining the detection result of the insulation state of the high-voltage component, a high-voltage component next to the high-voltage component to get powered up with a high voltage until detection results of insulation states of all high-voltage components are obtained.

In an embodiment, the detection unit is further configured to:
send a high-voltage power-up instruction to the high-voltage component, so as to instruct the high-voltage component to turn off an internal relay and get powered up with a high voltage based on the high-voltage power-up instruction; and
receiving a high-voltage power-up completion instruction returned by the high-voltage component, and determining that the high-voltage component has been powered up with the high voltage.

In an embodiment, the detection unit is further configured to:
compare the insulation resistance of the high-voltage component with a preset insulation fault resistance; and
determine, in a case that the insulation resistance of the high-voltage component is less than the insulation fault resistance, that the detection result of the insulation state of the high-voltage component is occurrence of an insulation fault; or determine, in a case that the insulation resistance of the high-voltage component is greater than or equal to the insulation fault resistance, that the high-voltage component passes the insulation state detection.

In an embodiment, the detection unit is further configured to:
detect, by the insulation monitoring module, an insulation resistance of the energy storage system; and
determine a detection result of the insulation state of the energy storage system based on the insulation resistance of the energy storage system.

In an embodiment, the detection unit is further configured to:
compare the insulation resistance of the energy storage system with a preset insulation fault resistance; and
determine, in a case that the insulation resistance of the energy storage system is less than the insulation fault resistance, that the detection result of the insulation state of the energy storage system is occurrence of an insulation fault; or, determine, in a case that the insulation resistance of the energy storage system is greater than or equal to the insulation fault resistance, that the energy storage system passes the insulation state detection.

In an embodiment, in a case that the detection result of the insulation state of the energy storage system is occurrence of an insulation fault, the detection unit is further configured to:
issue a high-voltage power-down instruction to each high-voltage component, so as to instruct each high-voltage component to get disconnected from the high voltage;
perform an insulation detection operation on each high-voltage component after the high-voltage component is disconnected from the high voltage, so as to determine a detection result of the insulation state of each high-voltage component; and
determine, based on the detection result of the insulation state of each high-voltage component, a high-voltage component that causes the insulation fault of the energy storage system.

In an embodiment, in a case that each to-be-monitored component is powered up with a low voltage, the detection unit is further configured to send an insulation detection start instruction to the insulation monitoring module. The insulation detection start instruction is used for switching the insulation monitoring module to an on-state.

In an embodiment, the detection unit is further configured to output a prompt message for any one to-be-monitored component in a case that the detection result of the insulation state of the to-be-monitored component is occurrence of an insulation fault. The prompt message is used for instructing the to-be-monitored component to get troubleshot and repaired to remove the insulation fault.

The modules of the insulation state detection apparatus may be implemented entirely or partly by software, hardware, or a combination thereof. The modules may be built in, or independent of, a processor of a computer device in hardware form, or may be stored in a memory of the computer device in software form, so as to be invoked by the processor to perform the corresponding operations.

In an embodiment, a computer device is provided. The computer device may be a server, and an internal structure diagram of the computer device may be shown in FIG. 17. The computer device includes a processor, a memory, and a network interface that are connected by a system bus. The processor of the computer device is configured to provide computing and control capabilities. The memory of the computer device includes a non-volatile storage medium and an internal memory. The non-volatile storage medium stores an operating system, a computer program, and a database. The internal memory provides an environment for operation of an operating system and a computer program in the non-volatile storage medium. The database of the computer device is used for storing data in an insulation state detection process. The network interface of the computer device is configured to communicate with an external terminal through a network connection. When executed by a processor, the computer program implements an insulation state detection method.

A person skilled in the art understands that the structure shown in FIG. 17 is a block diagram of just a part of the structure related to the solution of this application, and does not constitute any limitation on the computer device to which the solution of this application is applied. A specific computer device may include more or fewer components than those shown in the drawings, or may include a combination of some of the components, or may arrange the components in a different way.

In an embodiment, a computer device is provided, including a memory and a processor. The memory stores a computer program. When executing the computer program, the processor implements steps of the insulation state detection method according to any one of the embodiments of the method.

In an embodiment, a computer-readable storage medium is provided. The computer-readable storage medium stores a computer program. When executed by a processor, the computer program implements steps of the insulation state detection method according to any one of the embodiments of the method.

In an embodiment, a computer program product is provided. The computer program product includes a computer program. When executed by a processor, the computer program implements steps of the insulation state detection method according to any one of the embodiments of the method.

A person of ordinary skill in the art may understand that all or some of the processes of the methods in the foregoing embodiments may be implemented by a computer program instructing relevant hardware. The computer program may be stored in a nonvolatile computer-readable storage medium. When executed, the computer program can perform processes that include the foregoing method embodiments. Any reference to a memory, a database, or another medium used in each embodiment of this application may include at least one of a non-volatile memory or a volatile memory. Non-volatile memories may include read-only memory (Read-Only Memory, ROM), magnetic tape, floppy disk, flash memory, optical memory, high-density embedded non-volatile memory, resistive switching random-access memory (ReRAM), magnetoresistive random-access memory (Magnetoresistive Random Access Memory, MRAM), ferroelectric random-access memory (Ferroelectric Random Access Memory, FRAM), phase change memory (Phase Change Memory, PCM), graphene memory, or the like. Volatile memories may include a random-access memory (Random Access Memory, RAM), an external cache, or the like. Illustratively rather than restrictively, the RAM is in diverse forms, such as a static random access memory (Static Random Access Memory, SRAM) or a dynamic random access memory (Dynamic Random Access Memory, DRAM). The processor mentioned in each embodiment of this application may be, but is not limited to, a general-purpose processor, central processing unit, graphics processing unit, digital signal processor, programmable logic device, quantum computing-based data processing logic device, or the like.

Finally, it is hereby noted that the foregoing embodiments are merely intended to describe the technical solutions of this application but not to limit this application. Although this application has been described in detail with reference to the foregoing embodiments, a person of ordinary skill in the art understands that modifications may still be made to the technical solutions described in the foregoing embodiments, or equivalent replacements may still be made to some or all technical features in the technical solutions. Such modifications and equivalent replacements fall within the scope of the claims and specification hereof without making the essence of the corresponding technical solutions depart from the scope of the technical solutions of the embodiments of this application. Particularly, to the extent that no structural conflict exists, various technical features mentioned in different embodiments may be combined in any manner. This application is not limited to the specific embodiments disclosed herein, but includes all technical solutions falling within the scope of the claims.

## Claims

1. An insulation state detection method, applied to an energy management system, wherein the energy management system is communicatively connected to a plurality of to-be-monitored components and one insulation monitoring module separately, all the to-be-monitored components and the insulation monitoring module are connected to a same direct-current bus in parallel, and the method comprises:
detecting, by the insulation monitoring module in response to switching the insulation monitoring module to an on-state, an insulation state of each to-be-monitored component and an energy storage system sequentially based on a power-up and power-down sequence of the to-be-monitored components.

2. The method according to claim 1, wherein the power-up and power-down sequence comprises a low-voltage power-up state and a high-voltage power-up sequence, and the detecting, by the insulation monitoring module, an insulation state of each to-be-monitored component and an energy storage system sequentially based on a power-up and power-down sequence of the to-be-monitored components comprises:
obtaining the low-voltage power-up state of each to-be-monitored component and the high-voltage power-up sequence of high-voltage components in all the to-be-monitored components; and
detecting, by the insulation monitoring module, the insulation state of each to-be-monitored component and the energy storage system sequentially based on the low-voltage power-up state of each to-be-monitored component and the high-voltage power-up sequence of the high-voltage components in all the to-be-monitored components.

3. The method according to claim 2, wherein the detecting, by the insulation monitoring module, the insulation state of each to-be-monitored component and the energy storage system sequentially based on the low-voltage power-up state of each to-be-monitored component and the high-voltage power-up sequence of the high-voltage components in all the to-be-monitored components comprises:
detecting, by the insulation monitoring module, the insulation state of a low-voltage component in all the to-be-monitored components after a low voltage is applied to all the to-be-monitored components.
detecting, by the insulation monitoring module, the insulation state of each high-voltage component and the energy storage system based on the high-voltage power-up sequence of the high-voltage components in all the to-be-monitored components in a case that all low-voltage components have passed the insulation state detection.

4. The method according to claim 3, wherein the detecting, by the insulation monitoring module, the insulation state of a low-voltage component in all the to-be-monitored components comprises:
obtaining an insulation resistance, detected by the insulation monitoring module, of the low-voltage component; and
determining a detection result of the insulation state of the low-voltage component based on the insulation resistance of the low-voltage component.

5. The method according to claim 4, wherein the determining a detection result of the insulation state of the low-voltage component based on the insulation resistance of the low-voltage component comprises:
comparing the insulation resistance of the low-voltage component with a preset insulation fault resistance; and
determining, in a case that the insulation resistance of the low-voltage component is less than the insulation fault resistance, that the detection result of the insulation state of the low-voltage component is occurrence of an insulation fault; or, determining, in a case that the insulation resistance of the low-voltage component is greater than or equal to the insulation fault resistance, that the low-voltage component passes the insulation state detection.

6. The method according to any one of claims 3 to 5, wherein the detecting, by the insulation monitoring module, the insulation state of each high-voltage component and the energy storage system based on the high-voltage power-up sequence of the high-voltage components in all the to-be-monitored components comprises:
performing, based on the high-voltage power-up sequence of the high-voltage components, an insulation detection operation on each high-voltage component powered up with the high voltage, so as to detect the insulation state of each high-voltage component; and
detecting the insulation state of the energy storage system in a case that a high voltage has been applied to all the high-voltage components and all the high-voltage components have passed the insulation state detection.

7. The method according to claim 6, wherein the performing an insulation detection operation on each high-voltage component powered up with the high voltage comprises:
controlling, for any one high-voltage component, the high-voltage component to get powered up with a high voltage, and obtaining, by the insulation monitoring module, an insulation resistance of the high-voltage component powered up with the high voltage;
determining a detection result of the insulation state of the high-voltage component based on the insulation resistance of the high-voltage component powered up with the high voltage; and
controlling, based on the high-voltage power-up sequence after obtaining the detection result of the insulation state of the high-voltage component, a high-voltage component next to the high-voltage component to get powered up with a high voltage until detection results of insulation states of all high-voltage components are obtained.

8. The method according to claim 7, wherein the controlling a high-voltage component to get powered up with a high voltage comprises:
sending a high-voltage power-up instruction to the high-voltage component, so as to instruct the high-voltage component to turn off an internal relay and get powered up with a high voltage based on the high-voltage power-up instruction; and
receiving a high-voltage power-up completion instruction returned by the high-voltage component, and determining that the high-voltage component has been powered up with the high voltage.

9. The method according to claim 7, wherein the determining a detection result of the insulation state of the high-voltage component based on the insulation resistance of the high-voltage component powered up with the high voltage comprises:
comparing the insulation resistance of the high-voltage component with a preset insulation fault resistance; and
determining, in a case that the insulation resistance of the high-voltage component is less than the insulation fault resistance, that the detection result of the insulation state of the high-voltage component is occurrence of an insulation fault; or, determining, in a case that the insulation resistance of the high-voltage component is greater than or equal to the insulation fault resistance, that the high-voltage component passes the insulation state detection.

10. The method according to claim 6, wherein the detecting the insulation state of the energy storage system comprises:
detecting, by the insulation monitoring module, an insulation resistance of the energy storage system; and
determining a detection result of the insulation state of the energy storage system based on the insulation resistance of the energy storage system.

11. The method according to claim 10, wherein the determining a detection result of the insulation state of the energy storage system based on the insulation resistance of the energy storage system comprises:
comparing the insulation resistance of the energy storage system with a preset insulation fault resistance; and
determining, in a case that the insulation resistance of the energy storage system is less than the insulation fault resistance, that the detection result of the insulation state of the energy storage system is occurrence of an insulation fault; or, determining, in a case that the insulation resistance of the energy storage system is greater than or equal to the insulation fault resistance, that the energy storage system passes the insulation state detection.

12. The method according to claim 6, wherein the method further comprises:
issuing a high-voltage power-down instruction to each high-voltage component in a case that the detection result of the insulation state of the energy storage system is occurrence of an insulation fault, so as to instruct each high-voltage component to get disconnected from the high voltage;
performing the insulation detection operation on each high-voltage component after the high-voltage component is disconnected from the high voltage, so as to determine a detection result of the insulation state of each high-voltage component; and
determining, based on the detection result of the insulation state of each high-voltage component, a high-voltage component that causes the insulation fault of the energy storage system.

13. The method according to claim 12, **characterized in that** the determining, based on the detection result of the insulation state of each high-voltage component, a high-voltage component that causes the insulation fault of the energy storage system comprises:
determining, in a case that at least one of the high-voltage components fails the insulation state detection, that the high-voltage component failing the detection is the high-voltage component that causes the insulation fault of the energy storage system.

14. The method according to any one of claims 1 to 5, wherein, before the response to switching the insulation monitoring module to the on-state, the method further comprises:
sending an insulation detection start instruction to the insulation monitoring module in a case that each to-be-monitored component is powered up with a low voltage, wherein the insulation detection start instruction is used for switching the insulation monitoring module to the on-state.

15. The method according to any one of claims 1 to 5, wherein the method further comprises:
outputting a prompt message for any one to-be-monitored component in a case that the detection result of the insulation state of the to-be-monitored component is occurrence of an insulation fault, wherein the prompt message is used for instructing the to-be-monitored component to get troubleshot and repaired to remove the insulation fault.

16. An insulation state detection system, wherein the insulation state detection system comprises a plurality of to-be-monitored components and one insulation monitoring module, the plurality of to-be-monitored components and the insulation monitoring module are all communicatively connected to an energy management system, and all the to-be-monitored components and the insulation monitoring module are connected to a same direct-current bus in an energy storage system in parallel; and
the energy management system is configured to detect, by the insulation monitoring module in response to switching the insulation monitoring module to an on-state, an insulation state of each to-be-monitored component and the energy storage system sequentially based on a power-up and power-down sequence of the to-be-monitored components.

17. An energy storage system, wherein the energy storage system comprises the insulation state detection system according to claim 16.

18. An insulation state detection apparatus, wherein the apparatus comprises:
a detection module, configured to: detect, by an insulation monitoring module in response to switching the insulation monitoring module to an on-state, an insulation state of each to-be-monitored component and an energy storage system sequentially based on a power-up and power-down sequence of the to-be-monitored components in the energy storage system.

19. A computer-readable storage medium on which a computer program is stored, wherein the computer program implements steps of the method according to any one of claims 1 to 15 when executed by a processor.

20. A computer program product, comprising a computer program, wherein the computer program implements steps of the method according to any one of claims 1 to 15 when executed by a processor.
